# EUROPEAN PATENT APPLICATION

(11) **EP 3 799 542 A1**
(43) Date of publication of application: **31.03.2021**
(21) Application number: 20189052.2
(22) Date of filing: 08.06.2016
(51) Int. Cl.: H05K 3/28, B05D 1/00, B05D 5/08

(54) **METHOD FOR FORMING A COATING ON AN ELECTRONIC OR ELECTRICAL DEVICE**

(30) Priority: 09.06.2015 EP 15386018
(62) Divisional of application: 16739235.6
(71) Applicant: P2i Ltd, Abingdon, Oxfordshire OX14 4SA (GB)
(72) Inventor: Siokou, Angeliki, Abingdon, Oxfordshire OX14 4SA (GB); Hellwig, Thomas, Abingdon, Oxfordshire OX14 4SA (GB); Poulter, Neil, Abingdon, Oxfordshire OX14 4SA (GB); Evans, Delwyn, Abingdon, Oxfordshire OX14 4SA (GB); Telford, Clive, deceased (GB); Coulson, Stephen, Abingdon, Oxfordshire OX14 4SA (GB); Hopper, Fred, Abingdon, Oxfordshire OX14 4SA (GB)
(74) Representative: Greaves Brewster LLP

(57) **Abstract**

An electronic or electrical device or component thereof having a coating formed thereon by exposing said electronic or electrical device or component thereof to a plasma comprising one or more monomer compounds for a sufficient period of time to allow a protective polymeric coating to form on a surface thereof; wherein the protective polymeric coating forms a physical barrier over a surface of the electronic or electrical device or component thereof;
wherein each monomer is a compound of formula I(a): 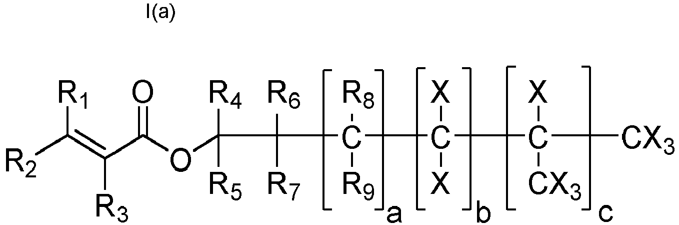 or
a compound of formula I(b) 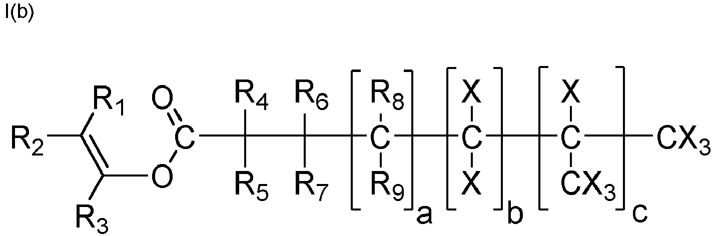 wherein each of R₁ to R₉ is independently selected from hydrogen or halogen or an optionally substituted C₁-C₆ branched or straight chain alkyl group; each X is independently selected from hydrogen or halogen; a is from 0-6; b is from 2 to 14; and c is 0 or 1; and wherein when each X is F or when at least one X is halogen, in particular F, the FTIR/ATR intensity ratio of CX₃/C=O of the coating is less than (c+1)0.6e^{-0.1n} where n is a+b+c+1; and wherein when each X is H the FTIR/ATR intensity ratio of CX₃/C=O is less than (c+1) 0.25±0.02, optionally wherein the barrier is a conformal physical barrier.

## Description

### Field of the invention

This invention relates to protective coatings. In particular, though not exclusively, the invention relates to substrates with protective coatings formed thereon, as well as methods of forming protective coatings on substrates.

### Background of the invention

It is well known that electronic and electrical devices are very sensitive to damage caused by contamination by liquids such as environmental liquids, in particular water. Contact with liquids, either in the course of normal use or as a result of accidental exposure, can lead to short circuiting between electronic components, and irreparable damage to circuit boards, electronic chips etc.

The problem is particularly acute in relation to small portable electronic equipment such as mobile phones, smartphones, pagers, radios, hearing aids, laptops, notebooks, tablet computers, phablets and personal digital assistants (PDAs), which can be exposed to significant liquid contamination when used outside or inside in close proximity to liquids. Such devices are also prone to accidental exposure to liquids, for example if dropped in liquid or splashed.

Other types of electronic or electrical devices may be prone to damage predominantly because of their location, for example outdoor lighting systems, radio antenna and other forms of communication equipment.

Protective coatings are known to mitigate the vulnerability of electronic and electrical devices to liquids. WO2007/083122 discloses electronic and electrical devices having a polymeric coating formed thereon by exposure to pulsed plasma comprising a particular monomer compound, for a sufficient period of time to allow a polymeric layer to form on the surface of the electrical or electronic devices. In general, an item to be treated is placed within a plasma chamber together with material to be deposited in the gaseous state, a glow discharge is ignited within the chamber and a suitable voltage is applied, which may be pulsed. Whilst the coating of internal components of electronic or electrical equipment, such as printed circuit boards (PCBs) is contemplated in passing in WO2007/083122, this is not exemplified and the main focus of the disclosure is on coating whole devices, particularly those containing microphones.

It is known in the art that applying a protective coating to electronic substrates presents particular difficulties. An electronic substrate may, in principle, be any electronic or electrical device or component that comprises at least one exposed electrical or electronic contact point. On the one hand, such substrates are particularly vulnerable, e.g. on account of electrochemical migration, and require highly effective barrier and repellent protection against liquids, frequently over complex surfaces, e.g. circuit board topographies. On the other hand, electrical or electronic contact points of such substrates may lose their functionality if coated with an overly thick protective layer, on account of increased electrical resistance. Similarly, microphones or speakers on or in the vicinity of electronic substrates can become blocked or damaged if coated too thickly.

Prior art coating technologies, including sprays, dips, gas phase processing systems such as Parylene, and even plasma deposition, have thus far been unable to form, especially over complex surfaces, protective coatings that are of a sufficient thickness and resistance to provide a high degree of protection against liquids, without adversely affecting contact point functionality.

One prior art approach for overcoming the paradox between protection and contact point functionality is P2i's Splash-proof technology, where a thin repellent protective coating is applied to both the outside and the inside of an assembled electronic or electrical device. This restricts liquid ingress whilst additionally preventing any ingressed liquid spreading within the device. Thus, the vast majority of any liquid challenge is prevented from getting into the device in the first instance, whilst there is some additional protection within the device that does not interfere with the functionality of contact points. However, this technology generally only provides protection against splashing and not against immersion of the device into liquid.

Another prior art approach has been to apply relatively thick protective coatings to electronic substrates, for example based on Parylene technology, whilst masking contact points and/or microphones and speakers to prevent deposition of coating thereon. However, this leads to complex processing that has proven impractical/cost prohibitive for mass manufacturing of portable electronic devices and the like.

There remains a need in the art for highly effective protective coatings that can be applied to electronic substrates without interfering adversely with contact points. Such coatings could further enhance the resistance of substrates to liquids and/or enable more efficient manufacture of protected substrates, particularly in the electronics industry. It is an object of the invention to provide a solution to this problem and/or at least one other problem associated with the prior art.

### Summary of the invention

The inventors have now developed highly effective protective coatings, and methods for producing them, which may suitably be used with the aim of preventing the ingress of water into a treated electronic device or preventing and mitigating electrochemical migration on a surface comprising an electronic circuit, but which do not require masking during application. These coatings are based on plasma deposited monomer compounds.

### Statement of Invention

An aspect of the present invention provides an electronic or electrical device or component thereof having a coating formed thereon by exposing said electronic or electrical device or component thereof to a plasma comprising one or more monomer compounds for a sufficient period of time to allow a protective polymeric coating to form on a surface thereof; wherein the protective polymeric coating forms a physical barrier over a surface of the electronic or electrical device or component thereof;
wherein each monomer is a compound of formula I(a): 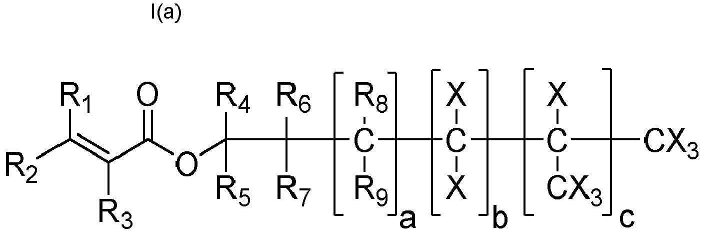 wherein each of R₁ to R₉ is independently selected from hydrogen or halogen or a C₁-C₆ branched or straight chain alkyl group; each X is independently selected from hydrogen or halogen; a is from 0-10; b is from 2 to 14; and c is 0 or 1;
and wherein when each X is F the FTIR/ATR intensity ratio of the peaks attributed to -CX₃ stretching and C=O stretching, CX₃/C=O, of the coating is less than (c+1)0.6e^{-0.1n} ±0.01 where n is a+b+c+1;
and wherein when each X is H the FTIR/ATR intensity ratio of CX₃/C=O is less than (c+1) 0.25±0.02; or
a compound of formula I(b): 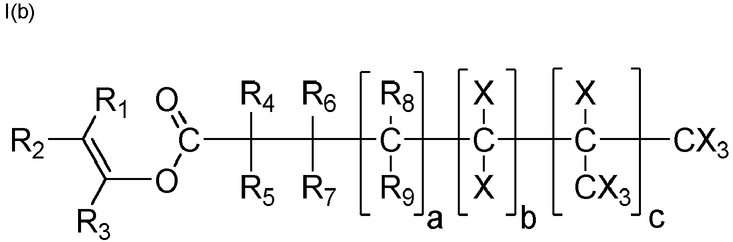 wherein each of R₁ to R₉ is independently selected from hydrogen or halogen or a C₁-C₆ branched or straight chain alkyl group; each X is independently selected from hydrogen or halogen; a is from 0-10; b is from 2 to 14; and c is 0 or 1; and wherein when each X is F the FTIR/ATR intensity ratio of the peaks attributed to -CX₃ stretching and C=O stretching CX₃/C=O of the coating is less than (c+1)0.6e^{-0.1n} ±0.01 where n is a+b+c+1; and wherein when each X is H the FTIR/ATR intensity ratio of CX₃/C=O is less than (c+1) 0.25±0.02.

When at least one X is halogen, in particular F, the FTIR/ATR intensity ratio of the peaks attributed to -CX₃ stretching and C=O stretching, CX₃/C=O, of the coating may be less than (c+1)0.6e^{-0.1n} ±0.01 where n is a+b+c+1.

Optionally, when each X is F, or when at least one X is halogen, in particular F, the FTIR/ATR intensity ratio of CX₃/C=O of the coating is less than (c+1)0.56e^{-0.11n} where n is a+b+c+1; and wherein when each X is H the FTIR/ATR intensity ratio of CX₃/C=O is less than (c+1) 0.16±0.01.

The coating protects the electronic or electrical device or component thereof by forming a physical barrier to mass and electron transport. The physical barrier restricts diffusion of water, O₂ or other ions with time/voltage. This physical barrier layer is distinct from the liquid repellent, typically water repellent, layer described in the prior art. It will be understood that the physical barrier layer of the present invention may be liquid repellent in addition to being a physical barrier, although the coating of the invention may be a physical barrier without being liquid repellent.

The halogen may be chlorine or bromine, but fluorine is preferred for compliance with RoHS regulations (Restriction of Hazardous Substances).
a is from 0 to 10, preferably from 0 to 6, optionally 2 to 4, most preferably 0 or 1. b is from 2 to 14, optionally from 2 to 10, preferably 3 to 7.

Each of R₁ to R₉ is independently selected from hydrogen or halogen or an optionally substituted C₁-C₆ branched or straight chain alkyl group. The alkyl group may be substituted or unsubstituted, saturated or unsaturated. When the alkyl group is substituted, the location or type of the substituent is not especially limited provided the resultant polymer provides an appropriate barrier layer. The skilled person would be aware of suitable substituents. If the alkyl group is substituted, a preferred substituent is halo, i.e. any of R₁ to R₉ may be haloalkyl, preferably fluoro alkyl. Any of the alkyl groups may also be substituted with one or more hydroxyl groups. If the alkyl group is unsaturated it may comprise one or more alkene or alkyne groups. Each of R₁ to R₉ may be independently selected from hydrogen, methyl, ethyl, n-propyl, isopropyl, n-butyl, isobutyl, tert-butyl, sec-butyl, n-pentyl, neopentyl, n-hexyl, isohexyl, and 3-methylpentyl. Preferably, each of R₁ to R₉ is independently selected from hydrogen or methyl.

In a preferred embodiment, a and c are each independently 0 or 1; and b is from 3 to 7.

In one preferred embodiment each X is H. In an alternative preferred embodiment each X is F.

Optionally R₁ and R₂ are both hydrogen.

Optionally R₃ is hydrogen or methyl. Preferably R₁ and R₂ are both hydrogen and R₃ is hydrogen or methyl.

In a preferred embodiment R₈ is hydrogen and R₉ is C₁-C₆ branched or straight chain alkyl group. In a particularly preferred embodiment, R₉ is methyl.

Preferably, each of R₄ to R₇ is hydrogen.

Optionally, each of R₁ to R₉ is hydrogen, each X is H, a=0 and c=0.

In a particularly preferred embodiment the compound of formula I(a) has the following formula: where n is from 2 to 10.

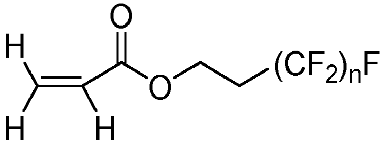

In another preferred embodiment the compound of formula I(a) has the following formula: 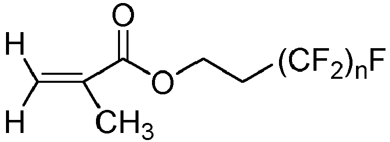 where n is from 2 to 10.

The compound of formula I(a) may be selected from 1H,1H,2H,2H-perfluorohexyl acrylate (PFAC4), 1H,1H,2H,2H-perfluorooctyl acrylate (PFAC6), 1H,1H,2H,2H-perfluorodecyl acrylate (PFAC8) and 1H,1H,2H,2H-perfluorododecyl acrylate (PFAC10).

The compound of formula I(a) may be selected from 1H,1H,2H,2H-pefluorohexyl methacrylate (PFMAC4), 1H,1H,2H,2H-perfluorooctyl methacrylate (PFMAC6) and 1H,1H,2H,2H-perfluorodecyl methacrylate (PFMAC8).

In another embodiment the compound of formula I(a) has the following formula: 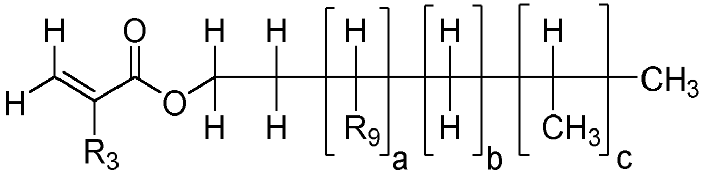 wherein a and c are each independently 0 or 1, b =3-7, where n=a+b+c+1.

In a further embodiment the compound of formula I(a) has the following formula: 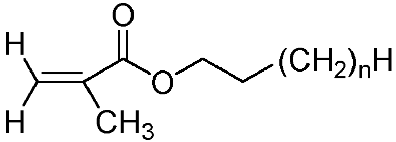 where n is 2 to 12.

The compound of formula I(a) may be selected from ethyl hexyl acrylate, hexyl acrylate, decyl acrylate, lauryl dodecyl acrylate and iso decyl acrylate.

In a further preferred embodiment the compound of formula I(b) has the following formula: 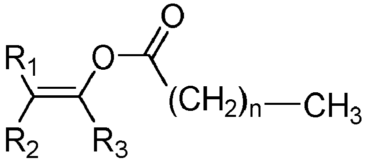 where n is from 3 to 13. Preferably n is 9.

The compound of formula I(b) most preferably has the following formula: 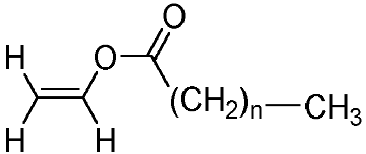 where n is from 3 to 13. n may be 6 to 10, preferably n is 9. ,i.e. vinyl decanoate.

Various alkenyl alkyl alkanoates are contemplated as monomers for the present invention. Preferred monomers are vinyl alkyl alkanoates, such as vinyl hexanoate, vinyl heptanoate, vinyl octanoate, vinyl nonanoate, most preferably vinyl decanoate. The hydrogens may be substituted for another chemical group at one or more positions. For example, the hydrogens may be substituted for halogen atoms, preferably fluoro.

External surfaces may comprise the external surface of the electronic or electrical device or component thereof, for example the housing of a device, such as a smart phone, or external surfaces of individual components which will later be assembled into a device, such as PCBAs and microphones. Where an electronic or electrical device or component thereof comprises a housing, internal surfaces may comprise, for example, the internal surface of a housing or the surface of the components housed within the housing.

In one embodiment, the electronic or electrical device or component thereof comprises a housing and wherein the coating forms a conformal physical barrier over an internal surface of the housing and/or surfaces of components within the housing. In this embodiment adequate protection is provided by the coating on the internal surfaces; the external surface of the housing may not be provided with a coating, which may be advantageous for cosmetic regions as well as reducing processing steps.

The FTIR/ATR intensity ratios of peaks attributed to stretching mode of CX₃ and C=O groups, CX₃/C=O , of the coating is indicative of sufficient cross linking in the coating to form a physical barrier. CX₃ refers to the terminal groups in the side chain of the compounds of formulas I(a) and I(b).

The coating formed by the present invention is more cross-linked than its conventionally polymerised counterpart, which explains its surprisingly good barrier performance. In some embodiments the polymer layer also provides repellence or resistance to liquid permeability. The coating may be electrically insulating. The combination of the barrier performance and optionally additionally the repellence of the coating of the present invention allows the coated electronic device or printed circuit board assembly (PCBA) to be submerged in water for at least 30 minutes without adverse effects. The electronic or electrical device or component thereof can typically withstand immersion in up to 1m of water for over 30 minutes without failure or corrosion whilst power applied to the electronic or electrical device or component.

The effectiveness of the coating can be determined by measuring its electrical resistance at a fixed voltage when submerged in water for a set time period; for example, when the protective polymeric coating is applied on a test printed circuit board (PCB). If it has a resistance of 8 MOhms or higher when submerged in water while a voltage of at least 16V/mm (for example 8V across a 0.5 mm gap between electrodes) is applied for a minimum of 13 minutes then it is an effective barrier coating and the coated electronic or electrical device or component thereof will pass successfully an IPX7 test. The IPX7 test is the Ingress Protection Marking which classifies and rates the degree of protection provided against water. In the IPX7 test for phones, the device is immersed in water under defined conditions of pressure and time (up to 1 m of submersion) for a duration of 30 minutes. The device has to be powered on during testing and functional after 24 hrs.

Formation of the barrier coatings of the present invention is believed to be caused by a mixture of cross linking and controlled fragmentation of the monomer during polymerisation. Cross linking is believed to be predominantly via the CX₂-CX₃ chain, whilst fragmentation is thought to be predominantly through loss of the C=O group during polymerisation and to a lesser extent shortening of the CX₂ chain.

Cross linking effects the abundance of -CX₃ groups in the coating and controlled fragmentation controls the amount of C=O groups in the coating. The ratio of these two functional groups is an indication that sufficient cross-linking and fragmentation has taken place and can be measured by the ratio of the intensities of the corresponding FTIR/ATR peaks.

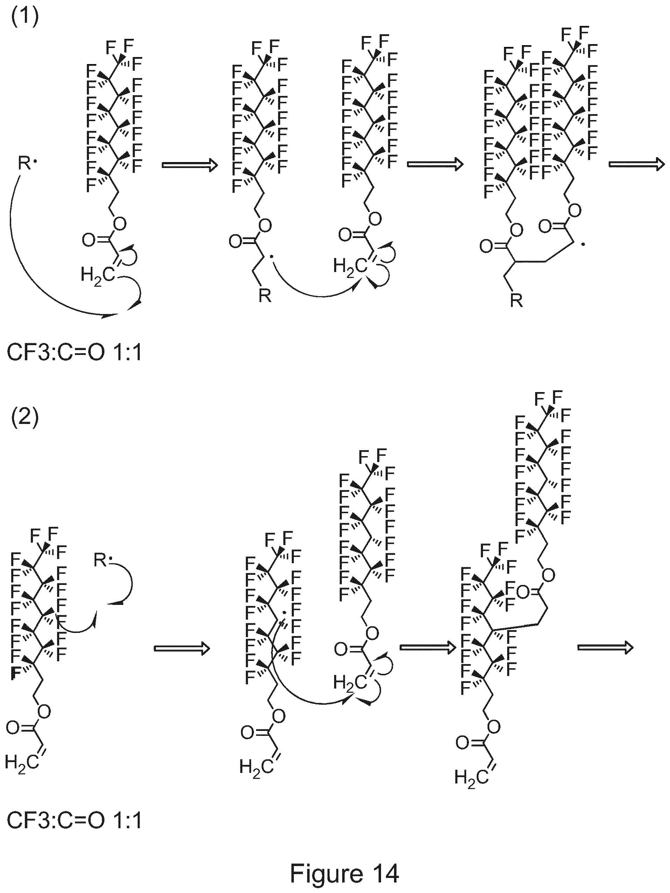

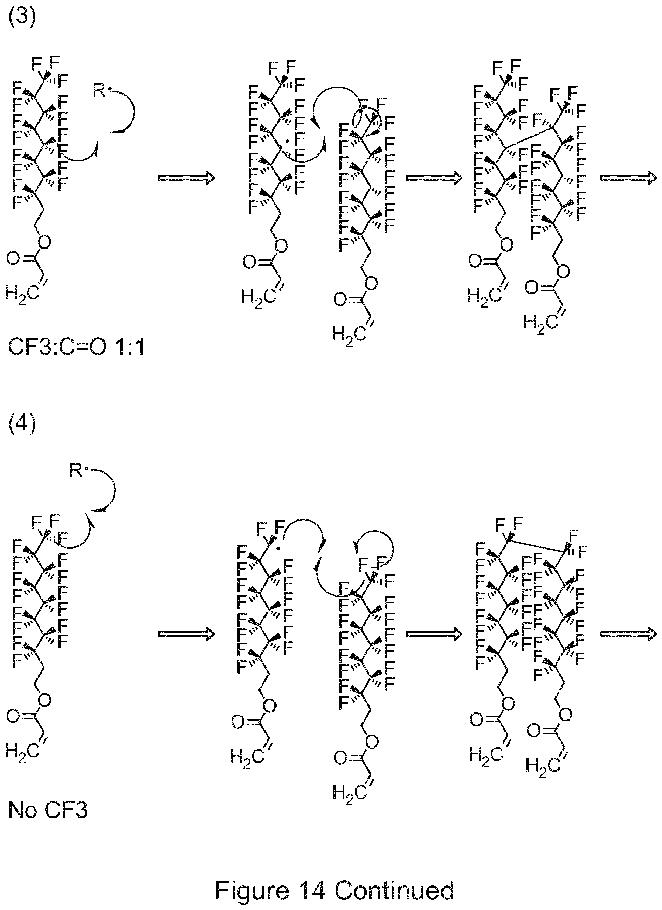

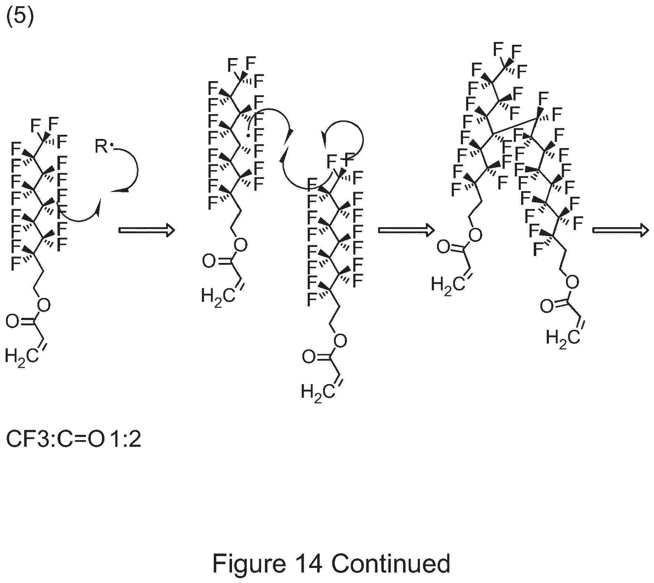

Possible mechanisms for cross linking of the monomer in the present invention are shown in Figure 14 which uses 1H, 1H, 2H, 2H-Perfluorodecyl acrylate (PFAC8) as an example. Schemes 1-3 give a CF₃:C=O ratio of 1:1; scheme 4 results in a polymer with no CF₃ groups; and scheme 5 results in a CF₃:C=O ratio of 1:2. Scheme 2 would have a CF₃:C=O ratio of 1:2 if the CF3 group was activated instead of CF2. Cross linking between CF2 and CF3 is believed to be the most likely mechanism (i.e. scheme 3).

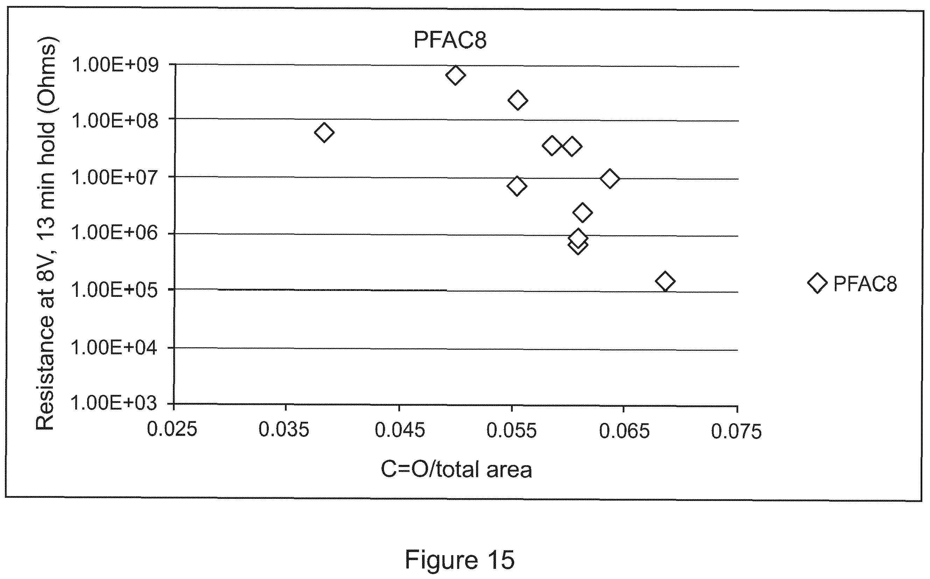

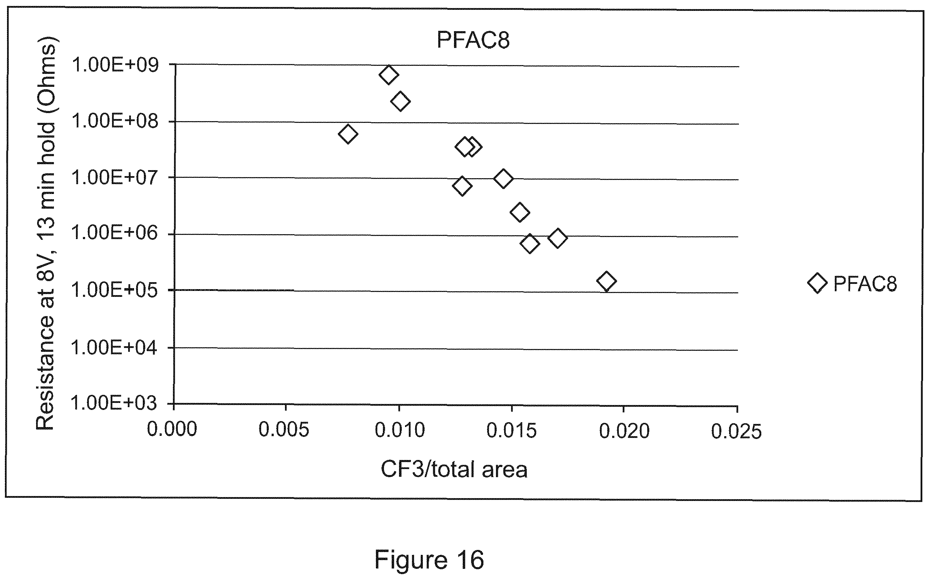

The degree of cross linking and fragmentation in the polymer can be discovered by measuring the FTIR/ATR peak intensities of the C=O and CX₃ functional groups. The ratios of C=O intensity/total intensity (area) of the ATR spectrum and CX₃/total intensity both correlate to the coating's performance. Figures 15 and 16 show graphs of the FTIR/ATR ratios against coating resistance (on applying 8V when immersed in water for 13 minutes) for C=O/total area and CX₃/total area respectively. Reduced CX₃ and C=O intensities give higher resistance values, showing an improved coating performance on increased cross linking (for CX₃) and fragmentation (for C=O).

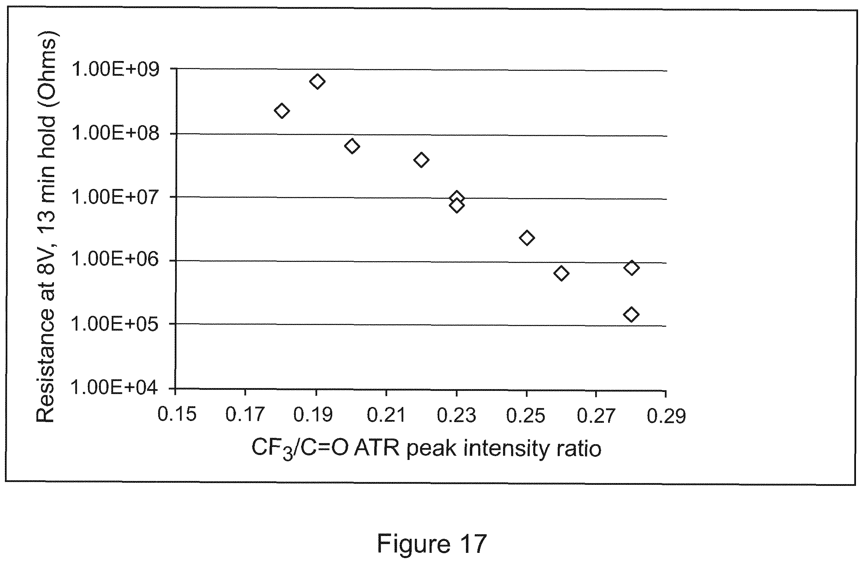

However their ratio (CX₃/C=O) gives the best correlation with coating resistance because it describes the combination of fragmentation and cross linking (see Figure 17).

For X=F the FTIR/ATR intensity ratio of CX₃/C=O in the monomer increases with chain length (i.e. value of a+b+c in formula I(a) or I(b) or n due to the dipole change with change of chain length. The actual ratio of CX₃/C=O groups in the polymer is not altered with monomer chain length.

In one embodiment, the compound of formula I(a) comprises a compound of formula (II) 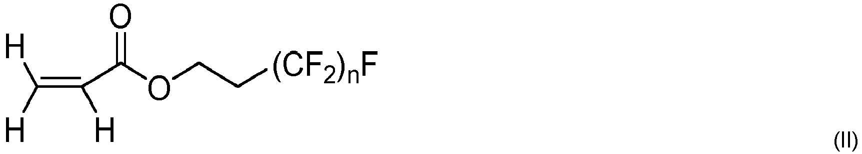
where n is 4 to 10 and
wherein the FTIR/ATR intensity ratio of CF₃/C=O of the coating is less than 0.6e^{-0.1n}.

The compound of formula (II) may be selected from 1H,1H,2H,2H-perfluorohexyl acrylate (PFAC4), 1H,1H,2H,2H-perfluorooctyl acrylate (PFAC6), 1H,1H,2H,2H-perfluorodecyl acrylate (PFAC8) and 1H,1H,2H,2H-perfluorododecyl acrylate (PFAC10).

In another embodiment, the compound of formula I(a) comprises a compound of formula (III). 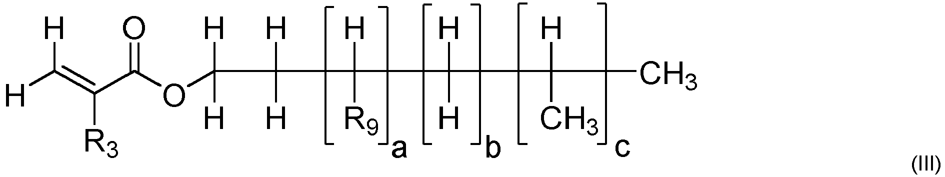 where a and c are either 0 or 1 and b=3-7; n is 4 to 10 (n=a+b+c+1) and wherein the FTIR/ATR intensity ratio of CH₃/C=O of the coating is less than (c+1) 0.25.

The compound of formula (III) may be selected from ethyl hexyl acrylate, hexyl acrylate, decyl acrylate, dodecyl (or lauryl)acrylate and iso decyl acrylate.

In another embodiment, the compound of formula I(a) comprises a compound of formula (IV) 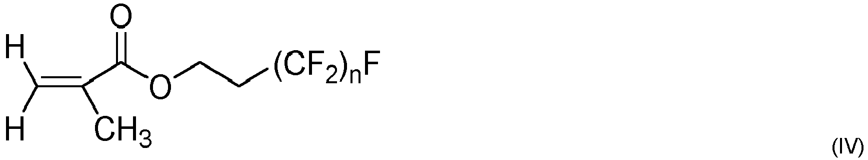
where n is 4 to 8; and
wherein the FTIR/ATR intensity ratio of CF3/C=O of the coating is less than 0.6e^{-0.1n}.

The compound of formula (IV) may be selected from 1H,1H,2H,2H-pefluorohexyl methacrylate (PFMAC4), 1H,1H,2H,2H-perfluorooctyl methacrylate (PFMAC6) and 1H,1H,2H,2H-perfluorodecyl methacrylate (PFMAC8).

In a further embodiment, the compound of formula (I) comprises a compound of formula (V) 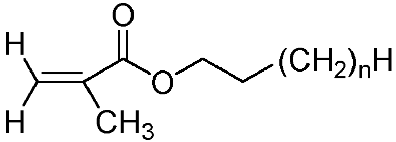
(V) where n is 4 to 8; and
wherein the FTIR/ATR intensity ratio of CH3/C=O of the coating is less than 0.25.

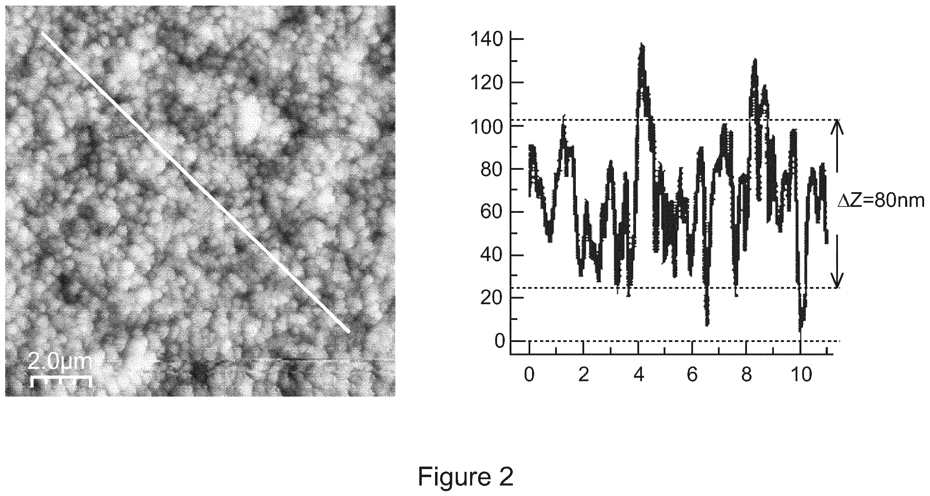

The coating is preferably substantially pin-hole free to enable it to provide a physical barrier. Zooming into the coating, preferably ΔZ/d <0.15, where ΔZ is the average height variation on an AFM line scan in nm (as shown in figure 2) and d is coating thickness in nm.

The value of ΔZ/d tells us to what extent defects/voids on the surface of the coating extend into the coating, i.e. the percentage value of the depth of defect over total coating thickness. For example, ΔZ/d = 0.15 means that the voids on the surface only extend down to 15% of the coating thickness. A coating with a ΔZ/d <0.15 is defined herein as being substantially pinhole free.

The coating is preferably conformal, which means that it takes the 3D shape of the electronic or electrical device or component thereof and covers substantially an entire surface of the device. This has the advantage of ensuring that the coating has sufficient thickness to give optimal functionality over an entire surface of the device or component. The meaning of the term "covers substantially an entire surface" will depend to some extent on the type of surface to be covered. For example, for some components, it may be necessary for there to be complete coverage of the surface in order for the component to function after submersion in water. However, for other components or housings, small gaps in coverage may be tolerated.

The coating may have a thickness of 50 to 10,000nm, optionally 50 to 8000nm, 100 to 5000nm, preferably 250nm - 5000nm, most preferably 250nm - 2000nm.

The coating may be electrically insulating and be sufficiently compliant that electrical connectors can be joined to the electronic or electrical device or component thereof and an electrical connection made between the electrical connectors and electronic or electrical device or component thereof without the requirement to first remove the coating. In this case, the force exerted by the electrical connector on the coating is sufficient to alter the structure of or even break through the coating local to the electrical connector, allowing the electrical connection to be made. Electrical connectors can typically be joined to the electronic or electrical device or component in this way for coating thicknesses of under 5000nm, and for high performance coatings below 2000nm.

In one embodiment, the coating is electrically insulating and has a thickness of less than 1 micron and wherein a force of 5- 20g applied to the coating using a round probe with 1 mm diameter allows an electrical connection to be made with the electronic or electrical device or component thereof in the local area where the force has been applied.

In another embodiment, the coating is electrically insulating and has a thickness of 1-2.5 microns and wherein a force of 20-100g applied to the coating using a round probe with 1 mm diameter allows an electrical connection to be made in the local area of the coating where the force has been applied.

The coating may have a higher density than that of the corresponding monomer from which it is formed. For example, the increase in density may be at least 0.1 g/cm³ The increase in density is explained by the highly crosslinked coating. The high density of the coating improves the barrier properties of the coating.

The coating may form a surface defined by a static water contact angle (WCA) of at least 70°. Coatings with a WCA of at least 90° may be described as liquid repellent (typically water repellent). In this case, the coating achieves liquid repellence in addition to providing a physical barrier. For fluorinated polymers, the coating may have a static water contact angle of at least 100°. The contact angle of a liquid on a solid substrate gives an indication of the surface energy which in turn illustrates the substrate's liquid repellence. Contact angles may be measured on a VCA Optima contact angle analyser, using 3 µl droplets of deionised water at room temperature.

The desired levels of cross linking and fragmentation in the polymeric coating to achieve the barrier performance are achieved by adjusting the process parameters. For example continuous wave (CW) conditions and/or pulsing under high power conditions have been found by the applicants to cause fragmentation and loss of C=O groups, whilst low power/flow ratios have been found to produce effective cross linking.

Another aspect of the invention provides a method for treating an electronic or electrical device or component as defined above, comprising:
exposing said electronic or electrical device or component thereof to a plasma comprising a one or more monomer compounds for a sufficient period of time to allow a protective polymeric coating to form on the electronic or electrical device or component thereof, the protective polymeric coating forming a physical barrier over a surface of said electronic or electrical device or component thereof;
wherein each monomer is a compound of formula I(a): 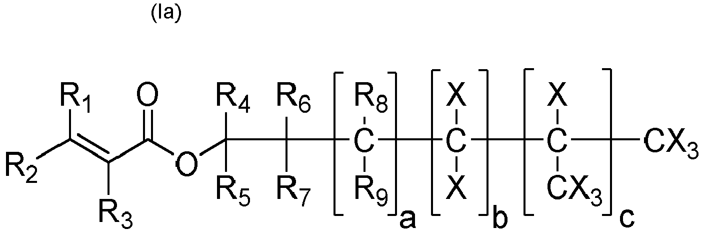 wherein each of R₁ to R₉ is independently selected from hydrogen or halogen or an optionally substituted C₁-C₆ branched or straight chain alkyl group; each X is independently selected from hydrogen or halogen; a is from 0-10; b is from 2 to 14; and c is 0 or 1; or
a compound of formula I(b): 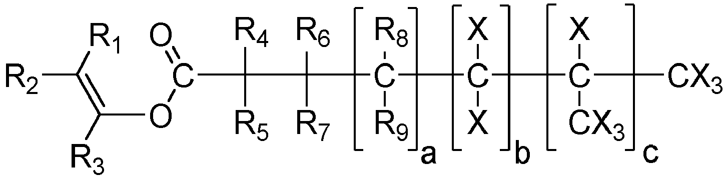 wherein each of R₁ to R₉ is independently selected from hydrogen or halogen or an optionally substituted C₁-C₆ branched or straight chain alkyl group; each X is independently selected from hydrogen or halogen; a is from 0-10; b is from 2 to 14; and c is 0 or 1.

The chemical structures of the monomers are described in detail above.

In order to achieve a polymeric coating forming a physical barrier over a surface of said electronic or electrical device the process parameters may be altered, for example, power, flow rate of monomer and monomer flow/power ratio.

The physical barrier is preferably a conformal physical barrier.

The step of exposing said electronic or electrical device or component thereof to a plasma may comprise a two step process, in which the first and second steps comprise different plasma conditions.

The step of exposing said electronic or electrical device or component thereto to a plasma may take place in a reaction chamber.

In a preferred embodiment the step of exposing said electronic or electrical device or component thereof to a plasma comprises a first continuous wave (CW) deposition step and second pulsed (PW) deposition step.

In one embodiment, a first step may comprise optimising process parameters for surface preparation and cross-linking to occur and a second step may comprise adjusting the process parameters to allow for further cross linking and increased fragmentation to occur. In this way, optimal cross linking (shown by lower CX₃ peak intensities in the FTIR/ATR spectra) and increased fragmentation (shown by lower C=O peak intensity in the FTIR/ATR spectra) are achieved. For example, the step of exposing said electronic or electrical device or component thereof to a plasma may comprise a first continuous wave (CW) deposition step and second pulsed (PW) deposition step.

The continuous wave (CW) deposition step has been found to act as a substrate priming step which optimise the coating's performance. The applicants have discovered that inclusion of a CW step optimises the interface between the substrate surface and growing coating, both causing some etching of the substrate surface and growth of the polymer coating. Inclusion of the CW deposition step leads to homogenous growth of the coating and minimises the probability of the formation of defects in the coating.

The pulsed (PW) deposition step has been found to be important in achieving good ingress of the coating into difficult to access areas. The applicants have surprisingly discovered that the quality and thickness of coating on internal surfaces can be optimised by adjusting the flow and power parameters. Increased power provided good quality coatings with the desired functionality on internal surfaces. Increased flow provided good quality coatings with the desired functionality on external surfaces.

The ratio of power/flow (W/F) of the PW deposition step can be adjusted, depending on the desired properties of the coated substrate: increasing W/F causes an increase on the resistance and quality of the internal coating but a decrease in external resistance and quality.

### FLOW RATE

The flow rate of the monomer compound into the chamber may be much higher (on a per volume basis of the chamber) than that disclosed in the method of WO2007/083122. It has been found that this high flow rate of the monomer compound surprisingly facilitates the formation of polymeric coatings having desirable liquid repellent and/or barrier properties even at thicknesses that offer a low electrical resistance.

The exact flow rate of the monomer compound into the chamber may depend to some extent on the nature of the particular monomer compound being used, the nature of the substrate and the desired protective coating properties. In some embodiments of the invention the monomer compound is introduced into the chamber at a gas flow rate in the range of at least 1.5 sccm and preferably in the range of from 1.5 to 2500 sccm, optionally from 1.5 to 250 sccm, optionally from 1.5 to 200 sccm although this will depend on chamber volume. For a 2.5I chamber, the gas flow rate may be in the range of 1.5 to 20 sccm. The monomer gas flow is calculated from the liquid monomer flow considering that the monomer in the chamber acts like an ideal gas.

In a further embodiment, the invention resides in a method of forming a coating on an electronic or electrical device or component thereof, the method comprising: exposing said electronic or electrical device or component thereof in a chamber to a plasma comprising a monomer compound as defined above, preferably a pulsed plasma, for a sufficient period of time to allow a protective polymeric coating to form on the substrate, wherein during exposure of the substrate the monomer compound is introduced into the chamber at a rate in the range of from 100-10000 sccm/m³, more preferably in the range of 600-8000sccm/m³.

### PEAK POWER

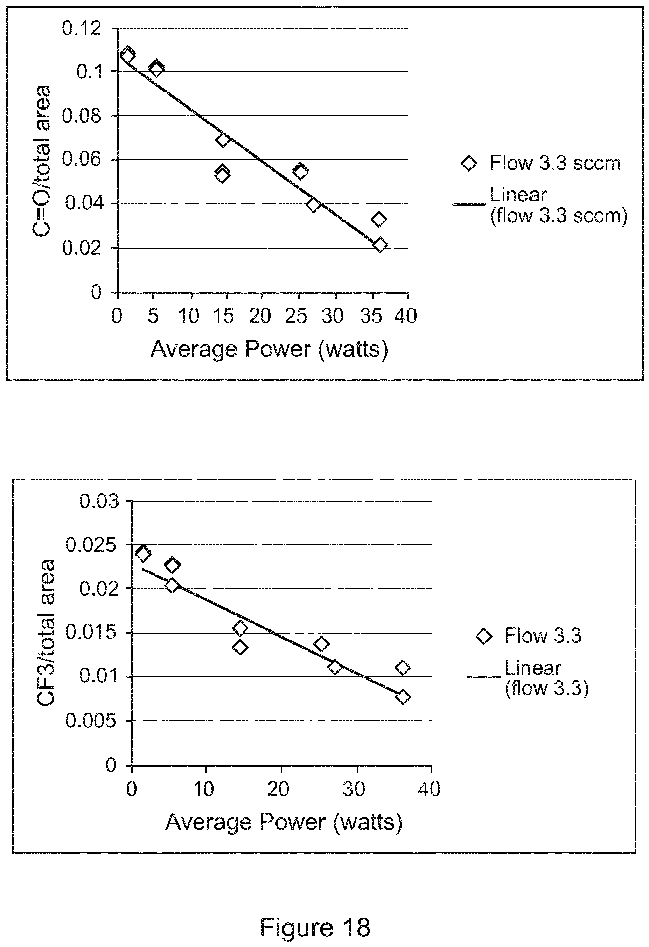

To achieve the desired level of cross linking and fragmentation for optimum coating performance, higher powers may be used than typically used in the prior art. Figure 18 shows how the FTIR/ATR intensity ratios of (A) C=O/total and (B) CF₃/total against power for PFAC4 coatings. The C=O/total data indicates increased fragmentation with increased power and the CF₃/total data indicates increased cross linking with increased power.

For pulsed plasmas, higher average powers can be achieved by using higher peak powers and varying the pulsing regime (i.e. on/off times).

In a further embodiment, the invention resides in a method of forming a coating on an electronic or electrical device or component thereof, the method comprising: exposing said substrate in a chamber to a plasma comprising a monomer as defined above, preferably a pulsed plasma, for a sufficient period of time to allow a protective polymeric coating to form on the substrate, wherein during exposure of the substrate the pulsed plasma has a peak power (e.g. on-phase) of at least 2W/litre.

It has been found that this high average power density of the plasma surprisingly facilitates the formation of polymeric coatings having desirable liquid repellent and/or barrier properties even at thicknesses that offer a low electrical resistance. This is due to the increased cross linking and/or fragmentation that occurs at higher powers.

The exact average power density of the plasma will depend to some extent on the nature of the particular monomer compound being used, the nature of the substrate and the desired protective coating properties. In some embodiments of the invention, the plasma may have an average power density in the range of from 0.001 to 20 W/litre. An average power density in the range of from 0.001-1 W/litre is particularly preferred for some type of compounds, for example compounds of formula II or formula III, n≥8. For other compounds, for example compounds of formula II or formula III for n<8 or when X=H an average power density in the range 2-12 W/litre may be preferred.

In one embodiment the plasma is a pulsed plasma in which pulses are applied in a sequence which yields a ratio of time on : time off in the range of from 0.001 to 1, optionally 0.002 to 0.5. For example, time on may be 10-500 µs, preferably 35-45 µs, or 30-40 µs, such as about 36 µs and time off may be from 0.1 to 30 ms, preferably 0.1 to 15 ms, optionally from 5 to 15 ms, for example 6ms. Time on may be 35 µs, 40 µs, 45 µs. Time off may be 0.1, 1, 2, 3, 6, 8, 10, 15, 20, 25 or 30 ms.

The term pulsed may mean that the plasma cycles between a state of no (or substantially no) plasma emission (off-state) and a state where a particular amount of plasma is emitted (on-state). Alternatively, pulsed may mean that there is continuous emission of plasma but that the amount of plasma cycles between an upper limit (on-state) and lower limit (off-state).

In a further embodiment, the invention resides in a method of forming a coating on an electronic or electrical device or component thereof as defined above, the method comprising: exposing said substrate in a chamber to a plasma comprising a monomer compound, preferably a continuous plasma, for a sufficient period of time to allow a protective polymeric coating to form on the substrate, wherein during exposure of the substrate the continuous plasma has a power density of at least 2W/litre, preferably 20W/litre.

### POWER TO FLOW RATIO

The power to monomer flow ratio during the pulsed plasma may be between 2-60 W/sccm preferably 2-40 W/sccm, 2-25 W/sccm, 5-20 W/sccm,

In a further embodimentt, the invention resides in a method of forming a coating on an electronic or electrical device or component thereof as defined above, the method comprising: exposing said electronic or electrical device or component thereof in a chamber to a plasma comprising a monomer compound, preferably a pulsed plasma, for a sufficient period of time to allow a protective polymeric coating to form on the substrate, wherein during exposure of the substrate the pulsed plasma has a peak power to flow ratio of between 2 to 60 W/sccm, preferably 2 to 40 W/sccm, more preferably from 2-25 W/sccm, optionally 5-20 W/sccm.

It has been found that this range of power to flow ratio surprisingly facilitates the formation of polymeric coatings having desirable liquid repellent and/or barrier properties even at thicknesses that offer a low electrical resistance.

In a further embodiment, the invention resides in a method of forming a coating on an electronic or electrical device or component thereof, the method comprising: exposing said electronic or electrical device or component thereof in a chamber to a plasma comprising a monomer compound, preferably a continuous plasma, for a sufficient period of time to allow a protective polymeric coating to form on the substrate, wherein during exposure of the substrate the continuous plasma has a power to flow ratio of between 2 to 60 W/sccm, preferably 2 to 40 W/sccm, more preferably from 2-25 W/sccm, optionally 5-20 W/sccm.

### PULSING /CW

The step of exposing said electronic or electrical device or component thereof to a plasma may comprise a pulsed (PW) deposition step. Alternatively, or in addition, the step of exposing said electronic or electrical device or component thereof to a plasma may comprise a continuous wave (CW) deposition step.

The aspects of the invention each provide methods facilitating the formation of highly effective protective coatings that can be applied to electronic substrates without interfering adversely with contact points. An advantage is that the resultant coating is sufficiently compliant such that electrical connectors can be joined after coating the device during or after manufacture and assembly. In one embodiment, the method includes the step of joining electrical connectors to the electronic or electrical device or component thereof after the coating has been applied. This has the advantage that electrical connectors can easily be joined to the electronic or electrical device or component thereof after coating the device or component during manufacture or assembly.

Notably, the features of the aspects of the invention work in synergy and give rise to preferred embodiments of the invention when combined. All such combinations, with or without any of the preferred and optional features recited herein, are explicitly contemplated according to the invention. For instance, in one preferred embodiment of the invention, a method of forming a coating on a substrate comprises: exposing said substrate in a chamber to a pulsed plasma for a sufficient period of time to allow a protective polymeric coating to form on the substrate, said plasma having a peak on-phase power of at least 2W/litre and comprising a hydrocarbon or fluorocarbon acrylate or methacrylate monomer compound, for example the compound of formula (la), introduced into the chamber during exposure of the substrate at a rate of at least 1.5 sccm or 2-100sccm or 2.5-20sccm.

In another preferred embodiment of the invention, a method of forming a coating on a substrate comprises expositing said substrate in a chamber to a continuous plasma for a sufficient period of time to allow a protective polymeric coating to form on the substrate, said plasma having a peak power of at least 15W/I and comprising a hydrocarbon or fluorocarbon acrylate or methacrylate monomer compound, for example the compound of formula (la), introduced into the chamber during exposure of the substrate of at least 2.5sccm.

The monomer may comprise a hydrocarbon or fluorocarbon acrylate or methacrylate. In particular, the monomer may comprise a compound of formula I(a): 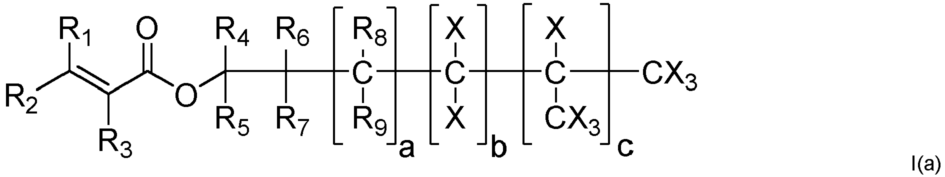 where R₁ and R₂ are both H, R₃ is hydrogen or methyl, R₄ to R₈ are each hydrogen, R₉ is an alkyl group, X is hydrogen or fluorine, a and c are either 0 or 1, b=3-7, and n is 4 to 10 (where n=a+b+c+1)

For X=F preferably the FTIR/ATR intensity ratio of CX₃/C=O of the resulting coating is less than (c+1) 0.6e^{-0.1n}, where n is as defined as being a+b+c+1.

For X=H preferably the FTIR/ATR intensity ratio of CX₃/C=O of the resulting coating is less than (c+1) 0.25, where n is as defined as being a+b+c+1.

An embodiment of the invention provides a method for treating an electronic or electrical device or component, comprising:
exposing said electronic or electrical device or component thereof to a plasma comprising one or more monomer compounds for a sufficient period of time to allow a protective polymeric coating to form on the electronic or electrical device or component thereof, the protective polymeric coating forming a physical barrier;
wherein each monomer is a compound of formula I(a): 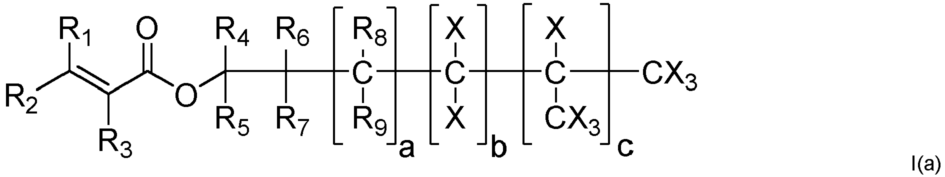
where R₁ and R₂ are both H, R₃ is hydrogen or methyl, R₄ to R₈ are each hydrogen, R₉ is an alkyl group, X is hydrogen or fluorine, a and c are either 0 or 1, b=3-7, and n is 4 to 10 (where n=a+b+c+1); and
wherein the step of exposing said electronic or electrical device or component thereof to a plasma comprises a first continuous wave (CW) deposition step and second pulsed (PW) deposition step.

The compound may be selected from 1H,1H,2H,2H-pefluorohexyl acrylate (PFAC4), 1H,1H,2H,2H-perfluorooctyl acrylate (PFAC6), 1H,1H,2H,2H-perfluorodecyl acrylate (PFAC8) and 1H,1H,2H,2H-perfluorododecyl acrylate (PFAC10).

In one embodiment, n is 8, X is F and R₃ is H, in which case the compound of formula I(a) is 1H,1H,2H,2H-heptadecafluorodecylacylate.

The compound may be selected from 1H,1H,2H,2H-pefluorohexyl methacrylate (PFMAC4), 1H,1H,2H,2H-perfluorooctyl methacrylate (PFMAC6) and 1H,1H,2H,2H-perfluorodecyl methacrylate (PFMAC8).

The compound of formula I(a) may be selected from ethyl hexyl acrylate, hexyl acrylate, decyl acrylate, lauryl dodecyl acrylate and iso decyl acrylate.

### SUBSTRATE

Although the invention is of benefit in the context of a wide variety of substrates, the substrate may, in all aspects of the invention, advantageously be an electronic substrate.

In some embodiments of the invention, the electronic substrate may comprise an electronic or electrical device, i.e. any piece of electrical or electronic equipment. Non-limiting examples of electrical and electronic devices include communications devices such as mobile phones, smartphones and pagers, radios, and sound and audio systems such as loudspeakers, microphones, ringers or buzzers, hearing aids, personal audio equipment such as personal CD, tape cassette or MP3 players, televisions, DVD players including portable DVD players, video recorders, digi and other set-top boxes such as Sky, computers and related components such as laptop, notebook, tablet, phablet or palmtop computers, personal digital assistants (PDAs), keyboards, or instrumentation, games consoles in particular hand-held playstations and the like, data storage devices, outdoor lighting systems or radio antenna and other forms of communication equipment.

In preferred embodiments of the invention, the substrate may comprise or consist of an electronic component, e.g. a printed circuit board (PCB), a printed circuit board array (PCBA), a transistor, resistor, or semi-conductor chip. The electronic component may thus be an internal component of an electronic device, e.g. a mobile phone. The coatings of the invention are particularly valuable in preventing electrochemical migration in such components.

In all aspects of the invention, the precise conditions under which the protective polymeric coating is formed in an effective manner will vary depending upon factors such as, without limitation, the nature of the monomer compound, the substrate, as well as the desired properties of the coating. These conditions can be determined using routine methods or, preferably, using the techniques and preferred features of the invention described herein, which work in particular synergy with the invention.

Suitable plasmas for use in the methods of the invention include non-equilibrium plasmas such as those generated by radiofrequencies (Rf), microwaves or direct current (DC). They may operate at atmospheric or sub-atmospheric pressures as are known in the art. In particular however, they may be generated by radiofrequencies (Rf).

Various forms of equipment may be used to generate gaseous plasmas. Generally these comprise containers or plasma chambers in which plasmas may be generated. Particular examples of such equipment are described for instance in WO2005/089961 and WO02/28548, the content of which is incorporated herein by reference, but many other conventional plasma generating apparatus are available.

In general, the substrate to be treated is placed within the plasma chamber together with the monomer compound, a glow discharge is ignited within the chamber, and a suitable voltage is applied. The voltage may be continuous wave or pulsed. Monomer may be introduced from the outset or following a period of preliminary continuous power plasma.

The monomer compound will suitably be in a gaseous state in the plasma. The plasma may simply comprise a vapour of the monomer compound if present. Such a vapour may be formed in-situ, with the compounds being introduced into the chamber in liquid form. The monomer may also be combined with a carrier gas, in particular, an inert gas such as helium or argon.

In preferred embodiments, the monomer may be delivered into the chamber by way of an aerosol device such as a nebuliser or the like, as described for example in WO2003/097245 and WO03/101621, the content of which is incorporated herein by reference. In such an arrangement a carrier gas may not be required, which advantageously assists in achieving high flow rates.

In some cases, a preliminary continuous power plasma may be struck for example for from 10 seconds to 10 minutes for instance for about 20 to 60 seconds, within the chamber. This may act as a surface pre- treatment step, ensuring that the monomer compound attaches itself readily to the surface, so that as polymerisation occurs, the coating "grows" on the surface. The pre-treatment step may be conducted before monomer is introduced into the chamber, for example in the presence of inert gas, or simply in a residual atmosphere. Monomer may then be introduced into the chamber to allow polymerisation to proceed, either switching the plasma to a pulsed plasma, continuing with a continuous plasma or using a sequence of both continuous and pulsed plasma.

In all cases, a glow discharge is suitably ignited by applying a high frequency voltage, for example at 13.56MHz. This is suitably applied using electrodes, which may be internal or external to the chamber.

Gases, vapours or aerosols may be drawn or pumped into the plasma chamber or region. In particular, where a plasma chamber is used, gases or vapours may be drawn into the chamber as a result of a reduction in the pressure within the chamber, caused by use of an evacuating pump, or they may be pumped or injected into the chamber as is common in liquid handling.

Suitably the gas, vapour or gas mixture may be supplied at a rate of at least 1.5 sccm and preferably in the range of from 1.5 to 100 sccm, more preferably 2.5 to 20 sccm, although this will depend on chamber volume. These amounts can be scaled up to larger systems on a chamber volume basis in accordance with the teaching herein.

Polymerisation is suitably effected using vapours of the monomer compound, which are maintained at pressures of from 0.1 to 200 mtorr, suitably at about 15-150 mtorr.

The applied fields may preferably provide a relatively high peak power density, e.g. as defined hereinabove in the method of the invention. The pulses may alternatively be applied in a sequence which yields a lower average power, for example in a sequence in which the ratio of the time on : time off is in the range of from 20:100 to 20 :20000 . Sequences with shorter time off periods may be preferred to maintain good power density. One example of a sequence is a sequence where power is on for 20 to 50 microseconds, for example 30 to 40 microseconds, such as about 36 microseconds, and off for from 5 to 30 milliseconds, for example 5 to 15 milliseconds, such as 6 milliseconds. This has been found to be of particular benefit when the monomer is a compound of formula (I).

Preferred average powers obtained in this way in a 2.5 litre chamber were in the range of from 0.05 to 30W. In some embodiments, particularly where compound of formula (I), where n is greater than or equal to 8 is used as monomer, relatively low average powers are preferred, e.g. in the range of from 0.1 to 5W, such as 0.15 to 0.5W in a 2.5 litre chamber. Higher average powers, for example over 10W have been found to have the advantage of aiding fragmentation of the monomer. These ranges may be scaled up or down on a volume basis for larger or smaller chambers and will depend on the selected peak power and pulse sequence.

The process temperatures, e.g. measured within the chamber, may be ambient, or preferably slightly above ambient, such as in the range of from 30 to 60 °C, e.g. 35 to 55 °C. In some embodiments, the process temperature is kept below 40°C.

Suitably a plasma chamber used may be of sufficient volume to accommodate multiple substrates, in particular when these are small in size, for example up to 20,000 PCBs can be processed at the same time with ease with the correct size equipment. A particularly suitable apparatus and method for producing coated substrates in accordance with the invention is described in WO2005/089961, the content of which is hereby incorporated by reference.

The dimensions of the chamber will be selected so as to accommodate the entirety of the particular substrate being treated. For instance, generally cuboid chambers may be suitable for a wide range of applications, but if necessary, elongate or rectangular chambers may be constructed or indeed cylindrical, or of any other suitable shape. The volume of the chamber may, for example be at least 1 litre, preferably at least 2 litres. In some applications, relatively small chambers with a volume of up to 13 litres or up to 10 litres are preferred. For large scale production, the volume of the chamber may suitably be up to 400 litres or higher. The chamber may be a sealable container, to allow for batch processes, or it may comprise inlets and outlets for substrates, to allow it to be utilised in a continuous process. In particular in the latter case, the pressure conditions necessary for creating a plasma discharge within the chamber are maintained using high volume pumps, as is conventional for example in a device with a "whistling leak". However it may also be possible to process certain substrates at atmospheric pressure, or close to, negating the need for "whistling leaks".

Advantageously, electronic or electrical contact points of the substrate need not be masked during exposure, in particular for coating with a thickness below 5µm, more preferably below 2µm. Indeed, in one embodiment of the invention, such contacts and/or microphones/speakers are not masked during formation of the coating by any of the methods as described herein, leading to an advantageously simplified process.

The invention has led to coatings that provide protective properties whilst maintaining contact point and microphone/speaker functionality. In a further embodiment, the invention resides in an electronic or electrical device or component thereof having a polymeric coating formed thereon by exposing said substrate to pulsed plasma comprising a monomer compound of formula (I) for a sufficient period of time to allow a protective polymeric coating to form on the substrate (for example according to any of the methods described herein), the coating having: a thickness of at least 50 nm and/or a surface defined by a static water contact angle (WCA) of at least 70°

More generally, from a further aspect, the invention resides in a substrate having a polymeric coating formed by any of the methods described herein. The invention also embraces coated substrates obtainable by any of the methods described herein.

One particular advantage of the invention is that electronic or electrical devices as a whole can be made resistant to liquids, even during full immersion, by coating only internal components such as PCBs, with an external coating no longer being necessary. Thus, from a further aspect, the invention resides in an electronic or electrical device, for example a mobile phone, comprising a housing and one or more internal electronic or electrical components with a coating formed thereon by any of the methods described herein. Advantageously, the housing need not comprise a coating. The device may advantageously pass standard IEC 60529 14.2.7 (IPX7).

More generally, any of the coated electronic substrates described herein may preferably continue to function even after full immersion into water for at least 2 minutes, preferably at least 5 minutes. The electronic substrate will preferably continue to function for at least 30 minutes or more preferably at least two days.

As used herein, the expression "in a gaseous state" refers to gases or vapours, either alone or in mixture, as well as optionally aerosols.

As used herein, the expression "protective polymeric coating" refers to polymeric layers which provide some protection against liquid damage, for example by forming a barrier and optionally being liquid (such as oil- and/or water-) repellent. Sources of liquids from which the substrate is protected may include environmental liquids such as water, in particular rain, as well as liquids that may be accidentally spilled.

As used herein, the expression "during the exposure of the substrate" refers to a time period in which the substrate is within the chamber together with the plasma. In some embodiments of the invention, the expression may refer to the entire time period in which the substrate is within the chamber together with the plasma.

Throughout the description and claims of this specification, the words "comprise" and "contain" and variations of the words, for example "comprising" and "comprises", mean "including but not limited to", and do not exclude other moieties, additives, components, integers or steps. Moreover the singular encompasses the plural unless the context otherwise requires: in particular, where the indefinite article is used, the specification is to be understood as contemplating plurality as well as singularity, unless the context requires otherwise. Furthermore, where upper and lower limits are quoted for a property, then a range of values defined by a combination of any of the upper limits with any of the lower limits may also be implied.

As used herein, the expression "FTIR/ATR" refers to Fourier Transform Infra-Red Spectroscopy (FTIR) using an Attenuated Total Reflection (ATR) sampling technique. This is a well known technique which will be understood by a person skilled in the art. Typically the ATR sampling is performed using a diamond crystal.

Preferred features of each aspect of the invention may be as described in connection with any of the other aspects. Other features of the invention will become apparent from the following examples. Generally speaking the invention extends to any novel one, or any novel combination, of the features disclosed in this specification (including any accompanying claims and drawings). Thus features, integers, characteristics, compounds, chemical moieties or groups described in conjunction with a particular aspect, embodiment or example of the invention are to be understood to be applicable to any other aspect, embodiment or example described herein unless incompatible therewith. Moreover unless stated otherwise, any feature disclosed herein may be replaced by an alternative feature serving the same or a similar purpose.

In this specification, references to compound properties are - unless stated otherwise - to properties measured under ambient conditions, i.e. at atmospheric pressure and at a temperature of from 16 to 22 or 25 °C, or from 18 to 22 or 25 °C, for example about 20 °C or about 25 °C.

Recited parameters, e.g. in relation to thickness, hydrophobicity, density and roughness of the coating, may be measured by any of the techniques defined in the Examples, or using standard techniques in the art. Unless specified otherwise, all values recited herein may be measured or determined using standard techniques known to those skilled in the art.

The present invention will now be further described with reference to the following non-limiting examples and the accompanying illustrative drawings, of which:
Figure 1 illustrates the electrical test apparatus for determining the resistance of the coating;
Figure 2 shows a tapping mode image of the coatings over 5x5 µm² field of view (left) and a representative contour line indicating height variation (z-axis) of the coating (right);
Figure 3 is a FTIR/ATR spectrum of a 1000 nm thick coating formed from PFAC8 monomer;
Figure 4 is a graph of Resistance in water of PW PFAC8 coatings at 8V after 13 min hold versus the FTIR/ATR CF3/C=O peak area ratio;
Figure 5 is a graph of the resistance in water of PW PFAC10 coatings at 8V after 13 min hold versus the FTIR/ATR CF3/C=O peak area ratio;
Figure 6 is a graph of the resistance in water of PW PFAC6 coatings at 8V after 13 min hold versus the FTIR/ATR CF3/C=O peak area ratio;
Figure 7 is a graph of the resistance in water of PW PFAC4 coatings at 8V after 13 min hold versus the FTIR/ATR CF3/C=O peak area ratio;
Figure 8 is a graph showing the ATR area ratios for the different perfluoro acrylate monomers;
Figure 9 is a graph showing the critical ATR ratio values as a function of the side chain length of the initial monomer;
Figure 10 is a graph showing the resistance in water of PW PFMAC8 coatings at 8V after 13 min hold versus the FTIR/ATR CF3/C=O peak area ratio;
Figure 11 is a graph showing the resistance in water of PW PFMAC6 coatings at 8V after 13 min hold versus the FTIR/ATR CF3/C=O peak area ratio;
Figure 12 is a graph showing the resistance in water of PW PFMAC4 coatings at 8V after 13 min hold versus the FTIR/ATR CF3/C=O peak area ratio; and
Figure 13 is a graph showing the critical FTIR/ATR ratio values as a function of the side chain length of the initial perfluoro-acrylate (PFACn) or perfluoro methacrylate (PFMACn) monomer;
Figure 14 illustrates possible cross linking mechanisms for PFAC8; and
Figure 15 is a graph of resistance (with applied 8V for 13 mins) against FTIR/ATR C=O/total area for PFAC8; and
Figure 16 is a graph of resistance (with applied 8V for 13 mins) against FTIR/ATR CF₃/total area for PFAC8; and
Figure 17 is a graph of resistance (with applied 8V for 13 mins) against FTIR/ATR CF₃/C=O;
Figure 18 is a graph of (A) FTIR/ATR C=O/total against power and (B) FTIR/ATR CF₃/total against power, both for PFAC4 coatings;
Figure 19 is a graph of contact force Fc against coating thickness;
Figure 20 is a graph of the resistance in water of ethyl hexyl acrylate coatings at 8V after 13 min hold versus the FTIR/ATR CH3/C=O peak area ratio;
Figure 21 is a graph of the resistance in water of hexyl acrylate coatings at 8V after 13 min hold versus the FTIR/ATR CH3/C=O peak area ratio;
Figure 22 is a graph of the resistance in water of iso decyl acrylate coatings at 8V after 13 min hold versus the FTIR/ATR CH3/C=O peak area ratio;
Figure 23 is a graph of the resistance in water of several non-fluorinated coatings at 8V after 13 min hold versus the FTIR/ATR CH₃/C=O peak area ratio; ethyl hexyl acrylate coating represented by diamonds; hexyl acrylate represented by squares; decyl acrylate represented by triangles; lauryl (dodecyl) acrylate represented by crosses; isodecyl acrylate represented by strikethrough crosses.

### Example 1

### Process set up and parameters

Plasma polymerization experiments were carried out in a cylindrical glass reactor vessel with a volume of 2.5 liters. The vessel was in two parts, coupled with a Viton O-ring to seal the two parts together under vacuum. One end of the reactor was connected to a liquid flow controller which was heated at 70°C and this was used for delivering monomer at a controlled flow rate.

The other end of the reactor was connected to a metal pump line fitted with pressure gauges, pressure controlling valve, liquid nitrogen trap and a vacuum pump. A copper coil electrode was wrapped around the outside of the reactor (11 turns of 5 mm diameter piping) and this was connected to a RF power unit via an L-C matching network. For pulsed plasma deposition the RF power unit was controlled by a pulse generator.

The monomer used for this example was PFAC-8, i.e. 1H,1H,2H,2H-heptadecafluorodecylacrylate (CAS # 27905-45-9) of formula

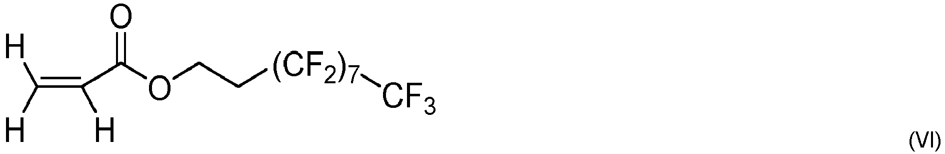

A range of experiments were carried out using the parameters shown in Tables 1A-1D. In each experiment a sample was placed inside the glass reactor vessel such that it sat on the bottom of the reactor vessel and inside the volume surrounded by the copper coil electrode. The reactor was evacuated down to base pressure (typically < 10 mTorr). The monomer was delivered into the chamber using the flow controller, which typical monomer gas flow values being between 2-25sccm. The chamber was heated to 45°C. The pressure inside the reactor was maintained at 30 mTorr. The plasma was produced using RF at 13.56 MHz and the process typically consisted of two main steps; the continuous wave (CW) plasma and the pulsed wave (PW). The CW plasma was for 2 minutes and the duration of the PW plasma varied in different experiments. The peak power setting was 50W in each case, and the pulse conditions were time on (Tₒₙ) = 37 µs and time off (T_{off}) = 6 ms. Two coatings were formed using Tₒₙ = 37 µs and T_{off}=20 ms. At the end of the deposition the RF power was switched off, the flow controller stopped and the chamber pumped down to base pressure. The chamber was the vented to atmospheric pressure and the coated samples removed.

For each experiment, two test PCBs and two Si wafers were used. The Si wafers allow physical properties of the formed coating to be measured, for example AFM for surface morphology and XRR for coating density. The metal tracks of the test PCBs were gold coated copper. The Si wafers were placed on the top front side of the PCBs.

Tables 1A-1D show the different process parameters for coatings formed in this example and the measured properties of these coatings.

### Example 2

A number of properties of exemplary coated substrates formed according to the invention were investigated.

### Resistance at fixed voltage overtime

This test method has been devised to evaluate the ability of different coatings to provide an electrical barrier on printed circuit boards and predict the ability of a smart phone to pass the IEC 60529 14.2.7 (IPX7) test. The method is designed to be used with tap water. This test involves measuring the current voltage (IV) characteristics of a standardised printed circuit board (PCB) in water. The PCB has been designed with spacing of 0.5 mm between electrodes to allow assessment of when electrochemical migration occurs across the tracks in water. The degree of electrochemical activity is quantified by measuring current flow; low current flow is indicative of a good quality coating. The method has proved to be extremely effective at discriminating between different coatings. The performance of the coatings can be quantified, e.g. as a resistance at 4 and 8V and 21 V. The measured resistance on the untreated test device is about 100 ohms when 16V/mm are applied.

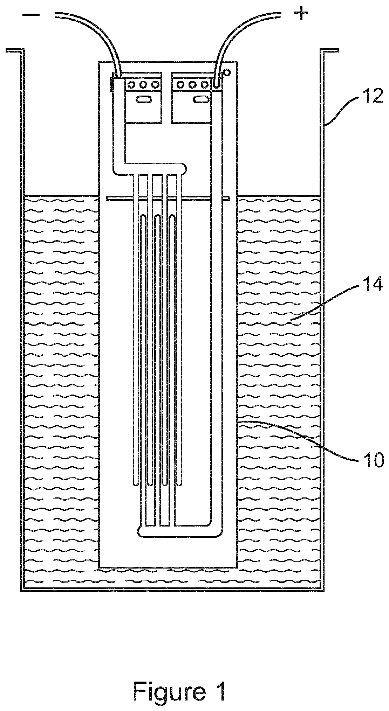

The coated PCB 10 to be tested is placed into a beaker 12 of water 14 and connected to the electrical test apparatus via connections 16,18 as shown Figure 1. The board is centred horizontally and vertically in the beaker to minimise effects of local ion concentration (vertical location of the board is very important; water level should be to the blue line). When the PCB is connected, the power source is set to the desired voltage and the current is immediately monitored. The voltage applied is for example 8V and the PCB is held at the set voltage for 13 minutes, with the current being monitored continuously during this period.

The coatings formed by the different process parameters are tested and the results are shown in Tables 1A-1D. It has been found that when coatings have resistance values higher that 8 MOhms, the coated device will pass successfully an IPX7 test. The nature of the device being coated (for example the type of smart phone) will influence the test, for example due to the variations in materials, ingress points, power consumption etc).

### Critical Force (Fc)

The electrical conductivity of a coating can change significantly when a compressive stress is applied to the coating. The change in the electrical conductivity will depend on the amplitude of strain experienced by the coating, amount of defects and type of polymer matrix of the coating. This behaviour is explained on the basis of formation or destruction of a conductive network, which further depends on the viscosity (stiffness) of the polymer matrix. To evaluate the ability of the coating to provide electrical contact under relatively low force, a contact force test is performed.

The contact force test is an electrical test procedure which involves measuring the critical force (Fc) or pressure (Pc) that has to be applied to the insulating coating via a flat probe, for electrical break down through the coating to occur. The test can be used either on PCBs of smart phones or on strip boards (Test PCBs) which are placed as witness samples during processes.

The test uses a flat probe e.g 1mm in diameter (or e.g a spherical probe of 2 mm diameter), contacting the planar film's surface. The probe is mounted on a support stand and the arrangement is such that variations in the force applied by the probe to the surface of the sample are immediately recorded by a weighing scale (or load cell) on which the sample is placed. With this arrangement the resolution in applied pressure is about 15 KPa (force 5g).

The normal procedure is to manually ramp the force applied by the probe on the planar surface of the sample while observing the resistance between the probe and the conductive substrate. The force is manually or automatically increased up to the point (Fc) where current break down through the film occurs.

This test allows the electrical insulation characteristics of the sample to be analyzed at a number of different points across the surface thus providing an idea of the uniformity of the surface layer.

The Fc values for the coated PCB coatings formed in Example 1 are shown in Tables 1A-1D.

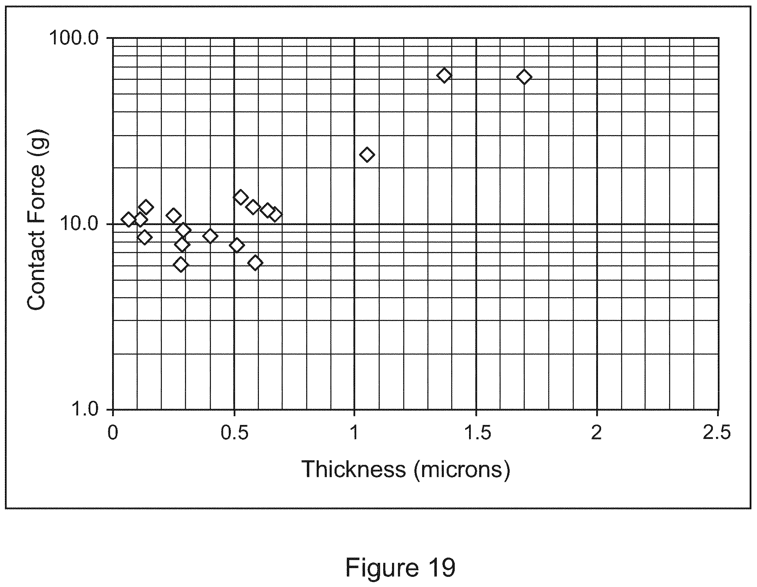

Figure 19 is a graph of Fc against coating thickness for PFAC8 made according to Example 1. This shows that a force of 20-100g can be applied to the coating with a thickness of 1-2.5 microns to allow an electrical connection to be made.

Typical Fc values for a coating with thickness of about 1000 nm is circa 35 g. The coating can achieve barrier functionality at relatively low (250-800nm) thickness, making it possible to achieve electrical contact after the application of relatively low (<15g) force. This is the advantage that coating of the present invention can provide when compared with other standard barrier coatings.

### Coating Thickness

The thickness of the coatings formed in Example 1 was measured using spectroscopic reflectometry apparatus (Filmetrics F20-UV) using optical constants verified by spectroscopic elipsometry.

### Spectroscopic Ellipsometry

Spectroscopic ellipsometry is a technique for measuring the change in polarization between incident polarized light and the light after interaction with a sample (i.e. reflected, transmitted light etc). The change in polarization is quantified by the amplitude ratio Ψ and phase difference Δ. A broad band light source is used to measure this variation over a range of wavelengths and the standard values of Ψ and Δ are measured as a function of wavelength. The ITAC MNT Ellipsometer is an AutoSE from Horiba Yvon which has a wavelength range of 450 to 850nm. Many optical constants can be derived from the Ψ and Δ values, such as film thickness and refractive index.

Data collected from the sample measurements includes the intensities of the harmonics of the reflected or transmitted signal in the predefined spectral range. These are mathematically treated to extract intensity values called Is and Ic as f(I). Starting from Ic and Is the software calculates Ψ and Δ. To extract parameters of interest, such as thickness or optical constants, a model has to be set up to allow theoretical calculation of Ψ and Δ. The parameters of interest are determined by comparison of the theoretical and experimental data files to obtain the best fit (MSE or X²). The best fit for a thin layer should give an X²<3, for thicker coatings this value can be as large as 15. The model used is a three layer Laurentz model including PTFE on Si substrate finishing with a mixed layer (PTFE+voids) to account for surface roughness.

Examples of optical properties of coatings formed in Example 1 are given in table 2. This data relates to coatings 9 and 10 in Tables 1A-1D.

### Spectroscopy Reflectrometry

Thickness of the coating is measured using a Filmetrics F20-UV spectroscopy reflectrometry apparatus. This instrument (F20-UV) measures the coating's characteristics by reflecting light off the coating and analyzing the resulting reflectance spectrum over a range of wavelengths. Light reflected from different interfaces of the coating can be in- or out-of-phase so these reflections add or subtract, depending upon the wavelength of the incident light and the coating's thickness and index. The result is intensity oscillations in the reflectance spectrum that are characteristic of the coating.

To determine the coating's thickness, the Filmetrics software calculates a theoretical reflectance spectrum which matches as closely as possible to the measured spectrum. It begins with an initial guess for what the reflectance spectrum should look like, based on the nominal coating stack (layered structure). This includes information on the thickness (precision 0.2 nm) and the refractive index of the different layers and the substrate that make up the sample (refractive index values can be derived from spectroscopic ellipsometry). The theoretical reflectance spectrum is then adjusted by adjusting the coating's properties until a best fit to the measured spectrum is found. Measured coatings must be optically smooth and within the thickness range set by the system configuration requirements is shown in table 3.

The thicknesses of the coatings produced in Example 1 are shown in Tables 1A-1D, which typical thickness being 750-3500nm.

Alternative techniques for measuring thickness are stylus profilometry and coating cross sections measured by SEM.

### Surface Morphology

The surface morphology of the coatings is measured using atomic force microscopy (AFM). Analyses are carried out with a Veeco Park Autoprobe AFM instrument, operated in the tapping imaging mode, using Ultrasharp NSC12, diving-board levers with spring constants in the range 4-14 N/m, and with resonant frequencies in the range 150-310 kHz. A high-aspect ratio probe, with a radius of curvature at the tip apex of <10 nm and opening angle <20° was used. Fields of view of 10x10, 5x5 and 1x1 µm² were imaged, with the larger field of view being the more informative. Surface roughness, RMS (root mean square), was calculated by standard software, for each field of view. The images obtained were 256 x 256 pixels in all cases.

From the AFM morphological analysis of the coatings two parameters can be extracted; (a) the RMS roughness (r) of the coating and b) the ratio ΔZ/d whereas d is the thickness of the coating and ΔZ is explained below.

Figure 2 shows a tapping mode image over 10x10 µm² field of view (left hand side) of a specimen example (thickness d=1230 nm) prepared according to Example 1 and a contour line plot (right hand side) showing the data used for calculation of RMS roughness. The ΔZ value indicated on the plot has been taken over an area of the graph that represents the majority of the coating. Peaks that lie above the ΔZ range indicate large particles and troughs that fall below the ΔZ range show voids or pinholes in the coating. The width of the peaks also gives an indication of the particle size. The example shown is sample 7 in tables 1A-1D with RMS roughness(r) was 35 ± 3 nm and ΔZ=80± 10 nm giving ΔZ/d=0.065.

It has been shown that ΔZ/d<0.15, indicates a pinhole free coating. Morphological parameters are good indicators for pinhole free coatings. However, this property alone does not account for the high performance of the coating.

### Chemical Analysis

For samples with a thickness higher than 200 nm, a Fourier Transform Infra-Red Spectroscopy (FTIR) using an Attenuated Total Reflection (ATR) sampling technique is used for chemical characterization and coating quality assessment (FTIR/ATR analysis). The spectrometer used was an MIR Standard Perkin Elmer Frontier equipped with the Frontier UATR Diamond/ZnSe with 1 Reflection Top-Plate producing high quality spectra through the use of a pressure arm allowing good contact of the sample with the diamond crystal. Scan range of all measurements was 4,000-650cm⁻¹ with 0.4cm⁻¹ resolution and 10,000/1 pk-pk noise for a 5 second scan.

For the technique to be successful, the sample must be in direct contact with the ATR crystal. As with all FT-IR measurements, an infrared background is collected, in this case, from the clean ATR diamond crystal. The crystals are usually cleaned by using a solvent soaked piece of tissue. After the crystal area has been cleaned and the background collected, the solid sample is placed onto the small crystal area. The pressure arm should be positioned over the sample. Force is applied to the sample, pushing it onto the diamond surface. After the spectrum has been collected, the user must check that the crystal area is clean before placing the next sample on the crystal.

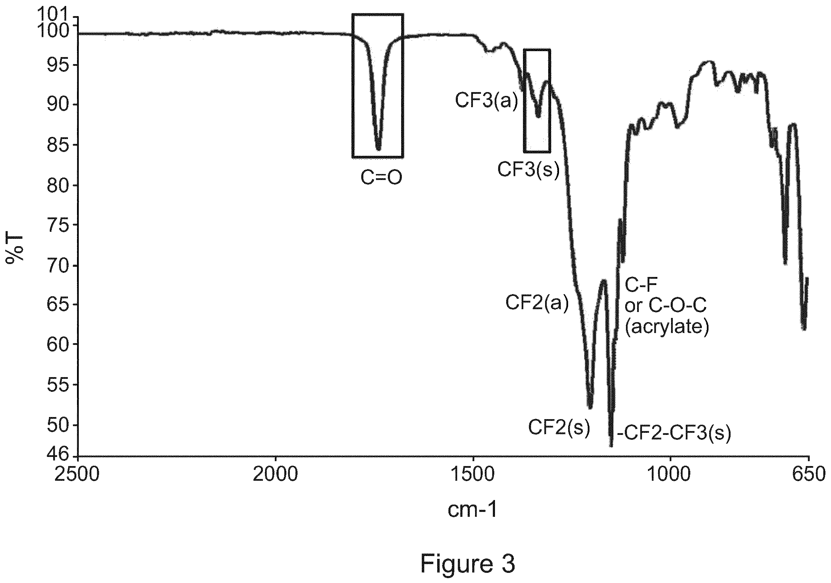

A typical FTIR/ATR spectrum from a 1000 nm thick coating prepared as described in Example 1 is shown in Figure 3. Assignments of the absorption peaks are also shown.

To analyse the data, a baseline is automatically subtracted from the spectrum, the integrated area under certain peaks of interest is measured, followed by the calculation of certain peak area ratios. The peak areas used for this analysis are shown in Figure 3 by rectangles surrounding the peaks of interest. The band assignments and the integration limits are shown in table 4.

The ratio between these two peak areas A (1335)/A(1737) is an important parameter characterising the chemistry and more specifically the degree of cross linking in the coating. It is found that coatings with thickness d>800 nm and A(1335)/A(1737<0.23±0.01 have undergone sufficient cross linking to have the desired functionality, providing they evenly cover the surface of the item under protection. It is established that plasma treatment would lead to the formation of a polymeric material that is far more cross-linked than its conventionally polymerised counterpart. Cross linking would affect the abundance of -CF3 functionalities in the coating.

Coatings with thickness d<800 nm require a correction to be applied to the measured ratio value A(1335)/A(1737) to account for the effect of the reduced thickness on the intensity of the selected FTIR/ATR peaks.

In this case, the corrected ratio = measured A(1335)/A(1737) - (-0.0003*d+0.255)
where d = coating thickness in nm.

### Physical Density measurements

The physical density of the coatings prepared in Example 1 was estimated gravimetrically and also by XRR for more accuracy on very thin coatings. The polymer coating with the desired properties has been found to have a higher density than the corresponding monomer due to cross linking, which is in agreement with the FTIR/ATR findings.

Table 5 shows the densities of three monomers and their resultant coatings, measured by X-ray Reflectometry (XRR). The coating formed from (I) is formed using the present method, whereas the coating formed from (II) is formed using a prior art method. The density values for Parylene C have been derived from literature [1].

It can be seen that the coating (I) formed from PFAC8 according to the present invention is significantly denser than coating (III) formed from the same monomer using prior art methods. It is also significantly denser than Parylene C coating, a conventionally used barrier coating.

### Relationship between resistance and FTIR/ATR data

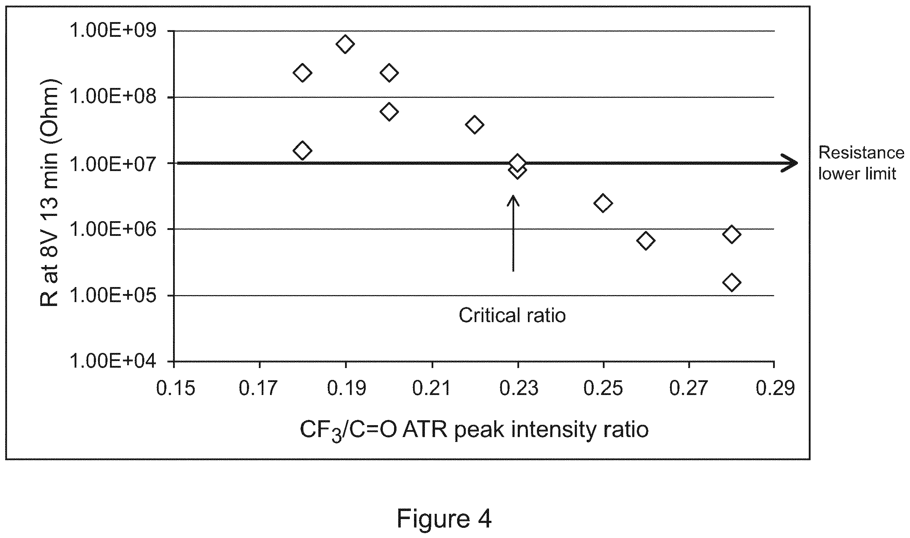

The relationship between the resistance value of the coating and the FTIR/ATR ratio of the CF3/C=O intensities is shown in Figure 4, using the data from tables 1A-1D. The resistance value is resistance at 8V for 13 minutes in tap water and the FTIR/ATR ratio refers to A(1535)/A(1737).

As discussed earlier, coatings with values for R higher than 8MOhms will pass an IPX7 test. Figure 4 shows that coatings with FTIR/ATR CF3/C=O values of less than 0.23 ± 0.01 meet this criterion. Looking at the results in tables 1A-1D, it can be seen that coatings 1,2,3 and 4 do not meet these criterion. These coatings have been produced with the lowest flow settings (∼2.2 sccm) while coatings 1 and 2 have the lowest average power setting.

From the Fc results in tables 1A-1D, it is also apparent that the coatings can be produced so that they provide Fc values below 45g.These values can become even lower (<10g) when the coatings are thinner than 800nm.

### Other perfluoroacrylate monomers

Similar high performing coatings have been produced with other perfuoro acrylate and methyl acrylate monomers with different side chain lengths (n=4,6,8 and 10), which are described in the following examples.

### Example 3 - PFAC10

The experiment of example 1 was repeated using PFAC10 (1H,1H,2H,2H-perfluorododecyl acrylate; CAS no. 17741-60-5) instead of PFAC8.

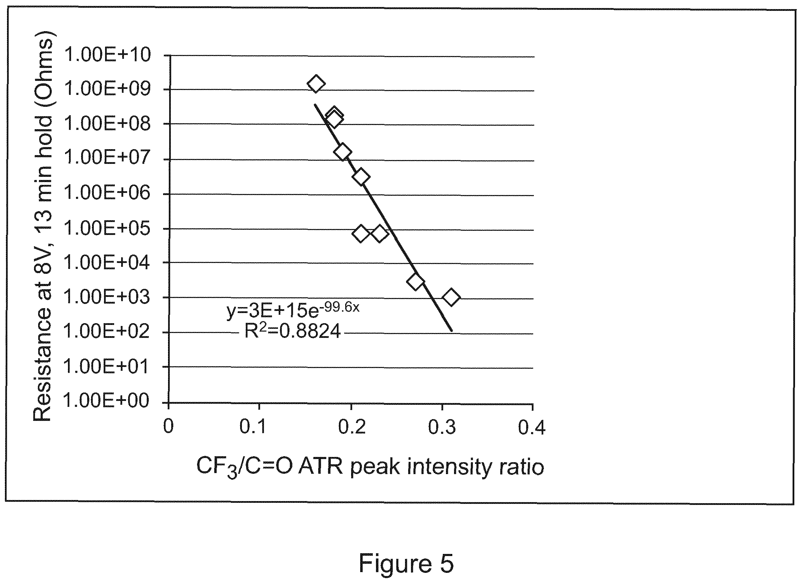

Figure 5 is a graph of resistance in water of PW PFAC10 coatings at 8V after 13 min hold versus the FTIR/ATR CF3/C=O peak area ratio.

Looking at coatings with values for R higher than 8MOhms (which will pass an IPX7 test), the critical value of the ATR CF3/C=O area ratio is 0.19±0.01.

### Example 4 - PFAC6

The experiment of example 1 was repeated using PFAC6 (1H,1H,2H,2H-perfluorooctyl acrylate; CAS no. 17527-29-6) instead of PFAC8.

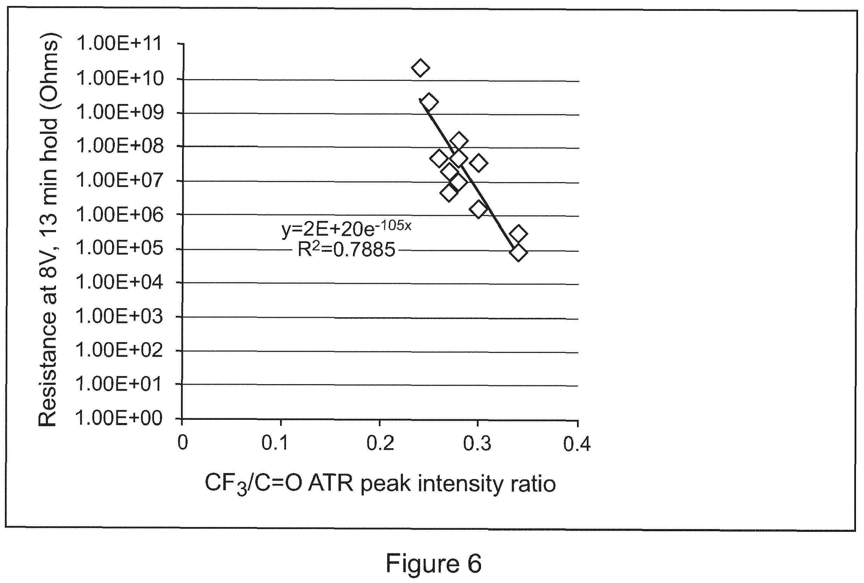

Figure 6 is a graph of resistance in water at 8V after 13 min hold versus the FTIR/ATR CF3/C=O peak area ratio is shown

Looking at coatings with values for R higher than 8MOhms (which will pass an IPX7 test), the critical value of the ATR CF3/C=O area ratio is 0.3±0.01.

### Example 5 - PFAC4

The experiment of example 1 was repeated using PFAC 4 (1H,1H,2H,2H-perfluorohexyl acrylate; CAS no. 52591-27-2) instead of PFAC8.

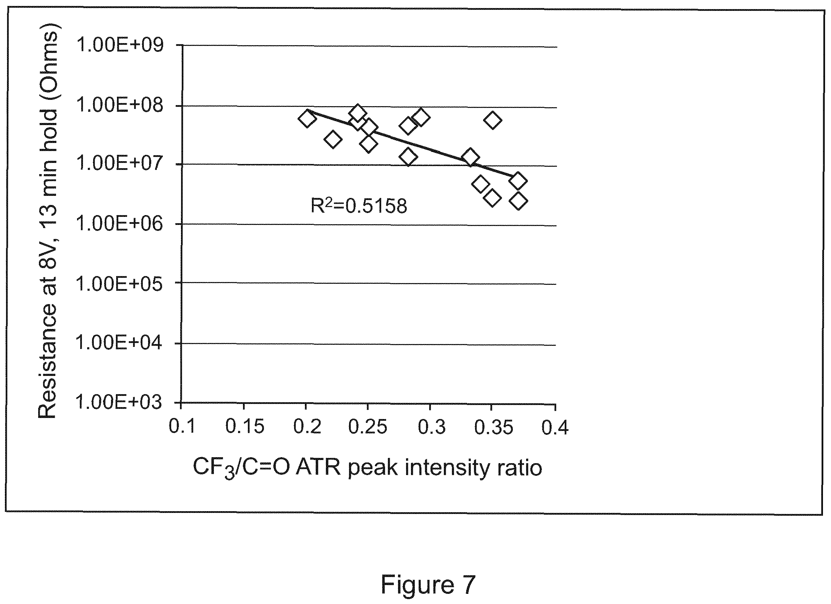

Figure 7 is a graph of resistance in water at 8V after 13 min hold versus the FTIR/ATR CF3/C=O peak area ratio is shown.

Looking at coatings with values for R higher than 8MOhms (which will pass an IPX7 test), the critical value of the ATR CF3/C=O area ratio is 0.36±0.02

### Analysis of perfluoroacrylate monomers.

For the examples 3-5, the FTIR/ATR area ratio between the peak representing the stretching mode of the end CF3 terminal group and the stretching mode of the C=O ester bond from the acrylate have been measured for each monomer and for each plasma polymer produced from those monomers.

The area limits used for these measurements are shown in Table 6.

The monomers PFAC4 - PFAC10 all have formula (II) below, 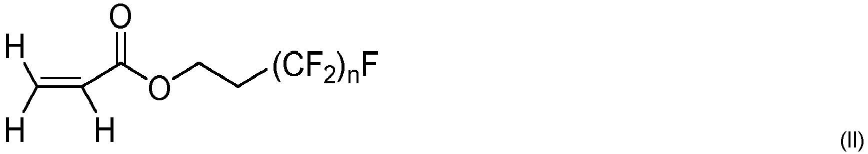 where n is 4 for PFAC4, 6 for PFAC6, 8 for PFAC8 and 10 for PFAC10.

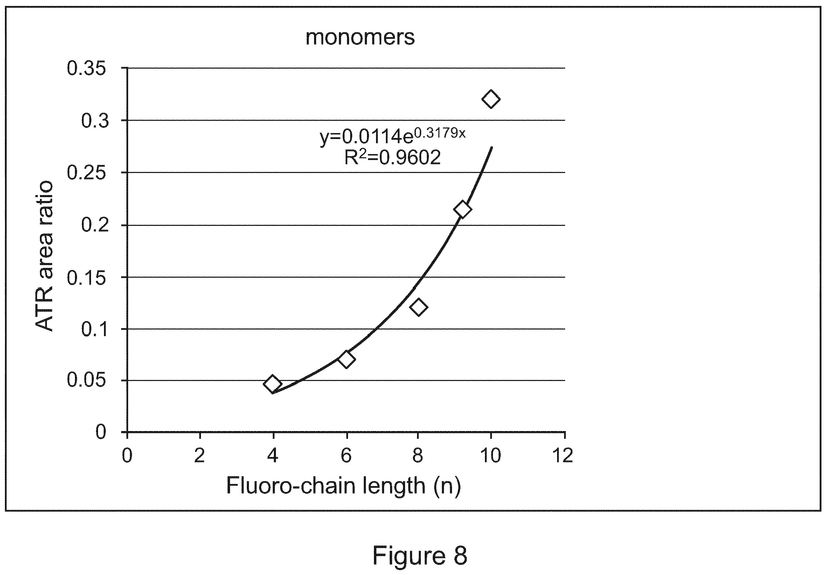

Figure 8 is a graph of the FTIR/ATR critical ratio (i.e. below which the coating provides good barrier functionality) against n and shows that the selected ATR area ratio for each monomer increases exponentially with the length of the side chain. This is expected because during the ATR measurement the evanescent wave will interact with dipoles in the film in all orientations defining the C-F bonding envelope of each substance measured. As the length of the side chain increases the intensity of the peak representing the CF3 stretching will increase along with the signal of peaks representing CF2 and CF2-CF3 vibration modes.

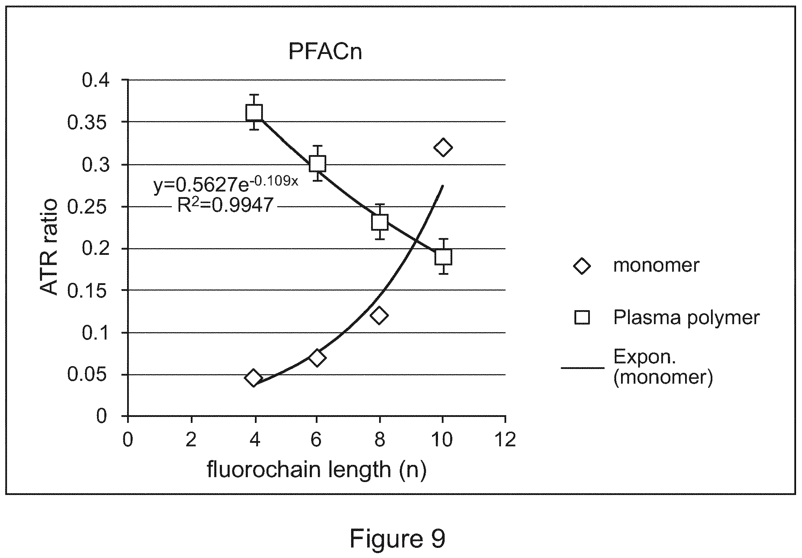

For each type of the plasma polymer prepared there is a corresponding functionality line like the one presented in Figure 4 for PFAC8 and a critical ATR ratio value. Figure 9 shows theses critical values for each polymer, as a function of the side chain length n of the monomer used to prepare this polymer.

It can be clearly seen that the values are related to the length (n) of the side chain by an exponential relationship. The applicants have realized that a coating with an FTIR/ITR ratio A(1)/A(2)<0.56e^{-0.11n} (integration limits given in Table 8) is a polymer with the desired functionality.

To identify the monomer from which the plasma polymer is produced, the ATR spectrum can be used. Table 7 shows the main features that differentiate the ATR spectra of the polymers.

### Perfluoro methacrylate monomers

High performing coatings have also been produced with perfluoro methyl acrylate monomers with different side chain lengths as defined in formula (IV) 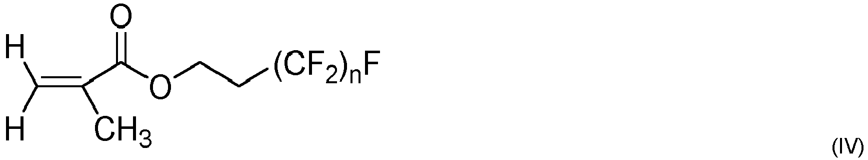 where n = 4,6,8 and 10. The resultant coatings are described in the following examples. The area limits used for these measurements are shown in Table 8.

### Example 6 - PFMAC8

The experiment of example 1 was repeated, using PFMAC8 (1H,1H,2H,2H-perfluorodecyl methacrylate; CAS no. 1996-88-9) in place of PFAC8.

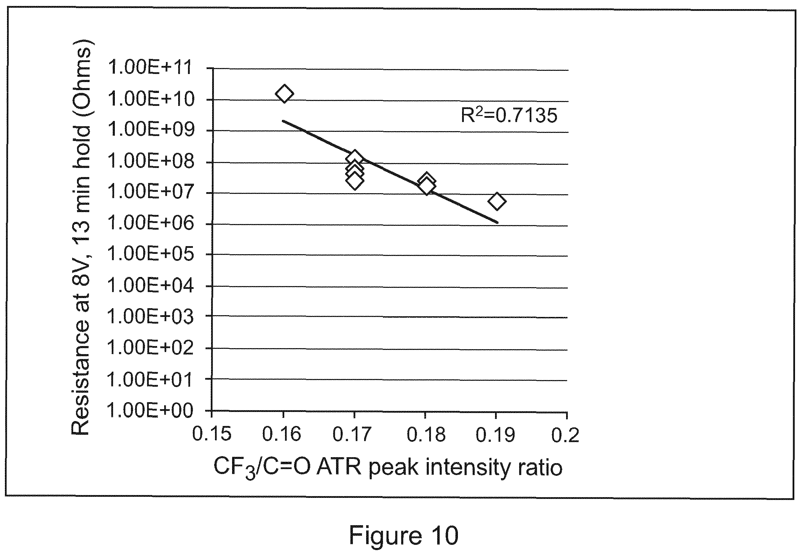

A graph of the resistance in water of PW PFMAC8 coatings at 8V after 13 min hold versus the FTIR/ATR CF3/C=O peak area ratio is shown in Figure 10.

The critical value of the ATR CF3/C=O area ratio is 0.19±0.01

### Example 7 - PFMAC6

The experiment of example 1 was repeated, using PFMAC6 (1H,1H,2H,2H-perfluorooctyl methacrylate; CAS no. 2144-53-8) in place of PFAC8.

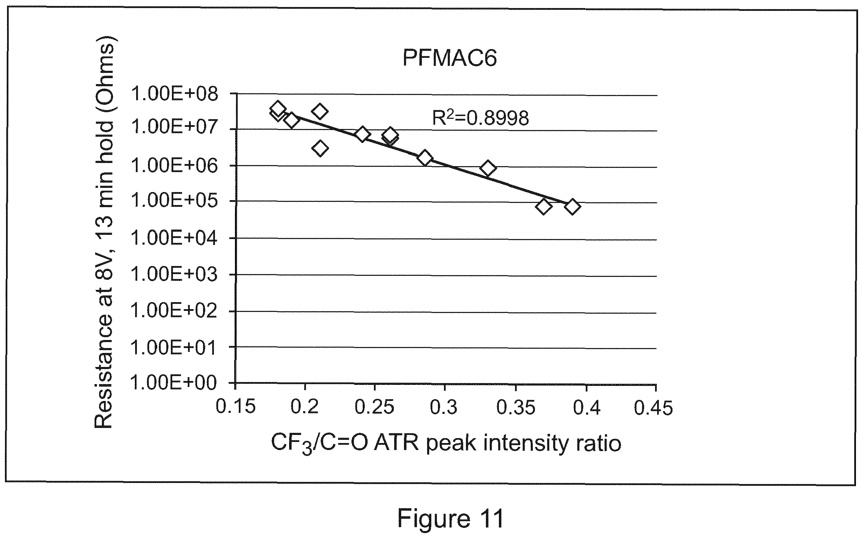

A graph of the resistance in water of PW PFMAC6 coatings at 8V after 13 min hold versus the FTIR/ATR CF3/C=O peak area ratio is shown in Figure 11.

The critical value of the ATR CF3/C=O area ratio is 0.24±0.02

### Example 8 - PFMAC4

The experiment of example 1 was repeated, using PFMAC4 (1H,1H,2H,2H-pefluorohexyl methacrylate; CAS no. 1799-84-4) in place of PFAC8.

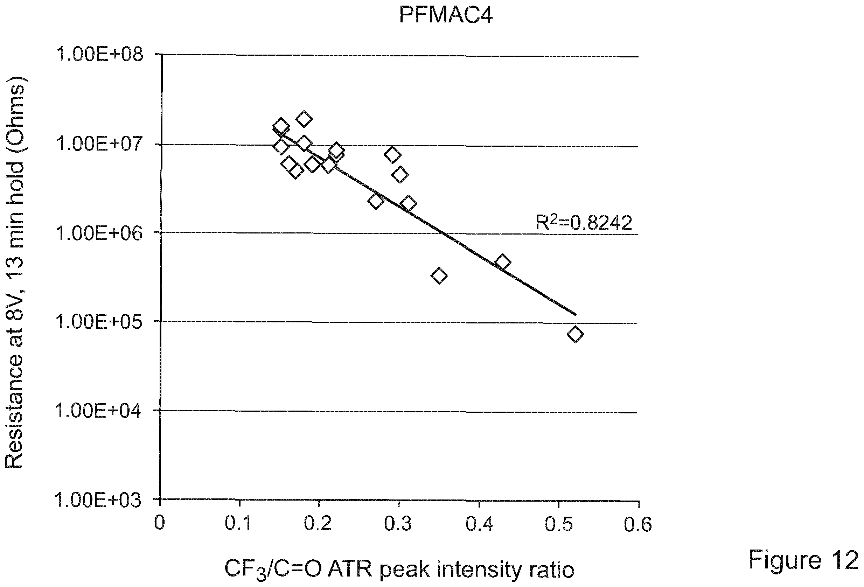

A graph of the resistance in water of PW PFMAC4 coatings at 8V after 13 min hold versus the FTIR/ATR CF3/C=O peak area ratio is shown in Figure 12.

The critical value of the ATR CF3/C=O area ratio is 0.31+0.02

### Analysis of PFACn monomers and PFMACn monomers.

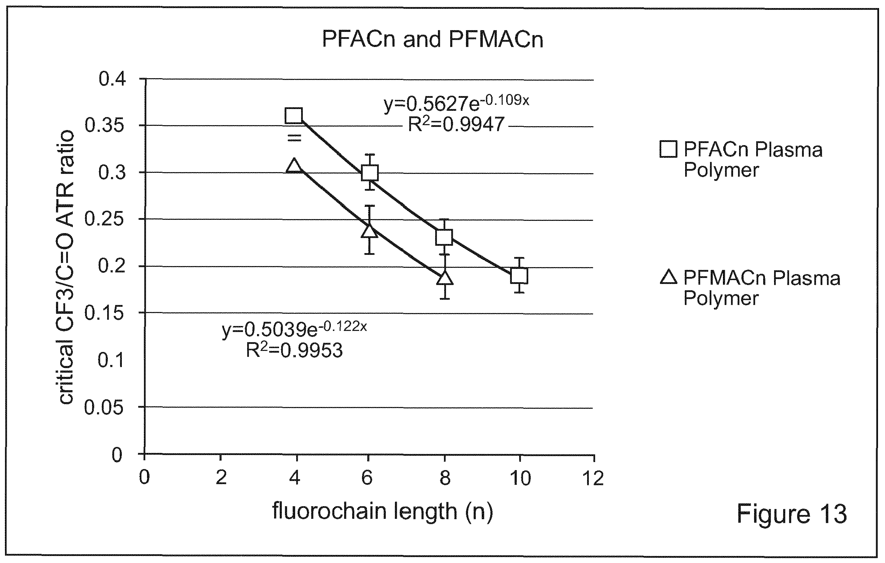

Figure 13 shows the critical FTIR/ATR ratio values as a function of the side chain length for the initial perfluoro-acrylate (PFACn) or perfluoro methacrylate (PFMACn) monomer and the resulting plasma polymers.

It can be seen that the critical FTIR/ATR CF3/C=O values for PFMACn coatings with the desired behavior follow the same trend as the PFACn coatings with an exponential relationship. For compounds of formula III, the applicants have realized that a value of the FTIR/ATR ratio A(1)/A(2), 0.50e^{-0.12n} results in a coating with the desired functionality.

### Example 9 - Parylene

The properties of Parylene coatings prepared by chemical vapour deposition (CVD) on the same substrates as the coatings described in examples 1 and 3-8, are shown in Table 16 for comparison purposes.

As shown in Table 9, Parylene coatings with resistance values above 8MOhms can only be achieved with coatings thicker than 2500 nm. When reaching these high thicknesses the coating detrimentally affects the operation of the device, as shown by the high critical force of over >250g. With such a high thickness, the coating does not allow sufficient electrical contact to be made under typical contact forces, making masking of contacts a necessary operation before the coating application.

High performing coatings have also been produced with non-fluorinated monomers as shown in Examples 10 to 12.

### Example 10

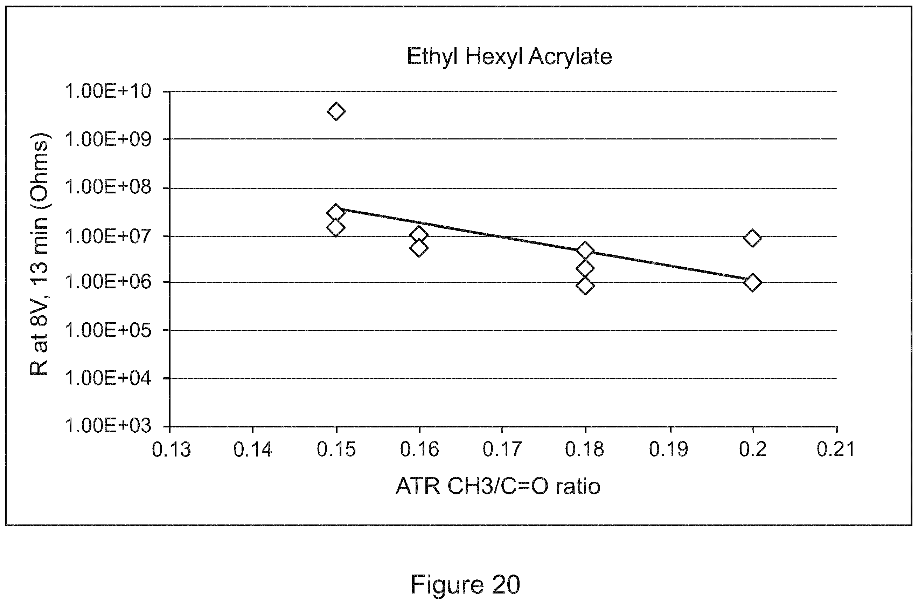

The experiment of example 1 was repeated, using ethyl hexyl acrylate (CAS no. 103-11-7) in place of PFAC8. 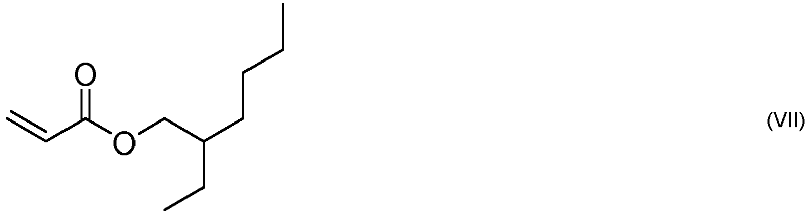 A graph of the resistance in water of ethyl hexyl acrylate coatings at 8V after 13 min hold versus the FTIR/ATR CH3/C=O
peak area ratio is shown in Figure 20.
The critical value of the ATR CH3/C=O area ratio is 0.16±0.01.

### Example 11

The experiment of example 1 was repeated, using hexyl acrylate (CAS no. 2499-95-8) in place of PFAC8.

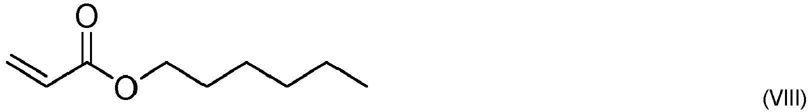

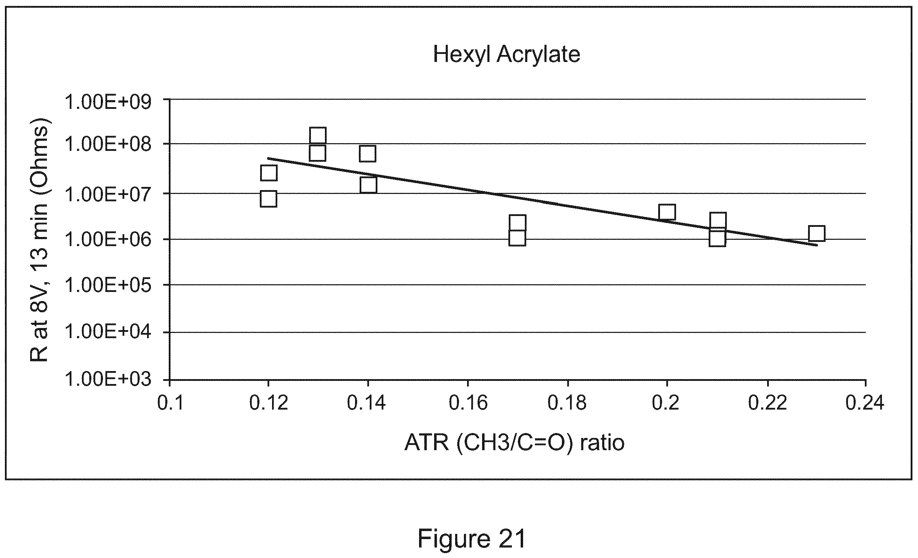

A graph of the resistance in water of hexyl acrylate coatings at 8V after 13 min hold versus the FTIR/ATR CH₃/C=O peak area ratio is shown in Figure 21.

The critical value of the ATR CH₃/C=O area ratio is 0.16±0.01.

### Example 12

The experiment of example 1 was repeated, using iso decyl acrylate (CAS no. 1330-61-6) in place of PFAC8.

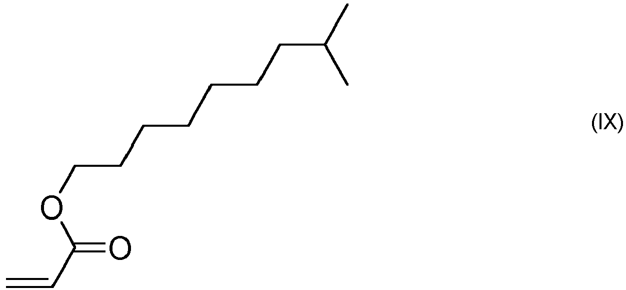

The process parameters and coating properties are given in Table 10.

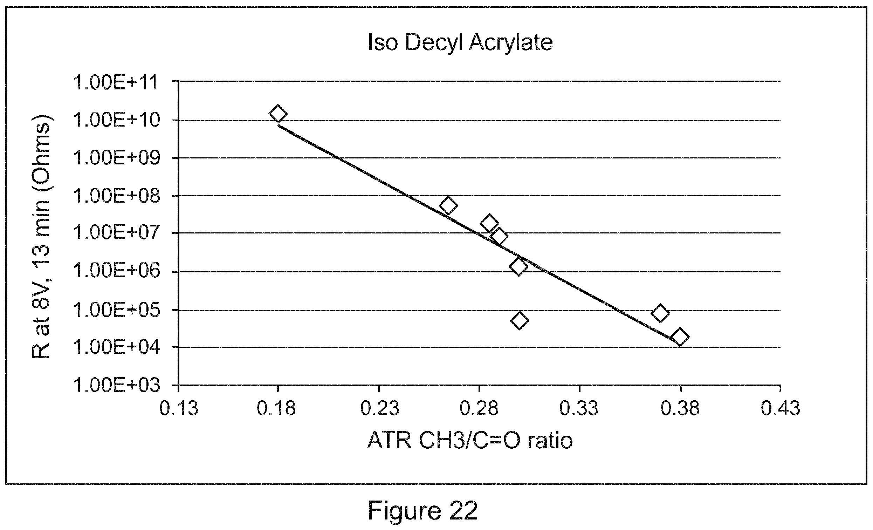

A graph of the resistance in water of iso decyl acrylate coatings at 8V after 13 min hold versus the FTIR/ATR CH₃/C=O peak area ratio is shown in Figure 22.

The critical value of the ATR CH₃/C=O area ratio is 0.30±0.01.

### Summary of non-fluorinated monomers

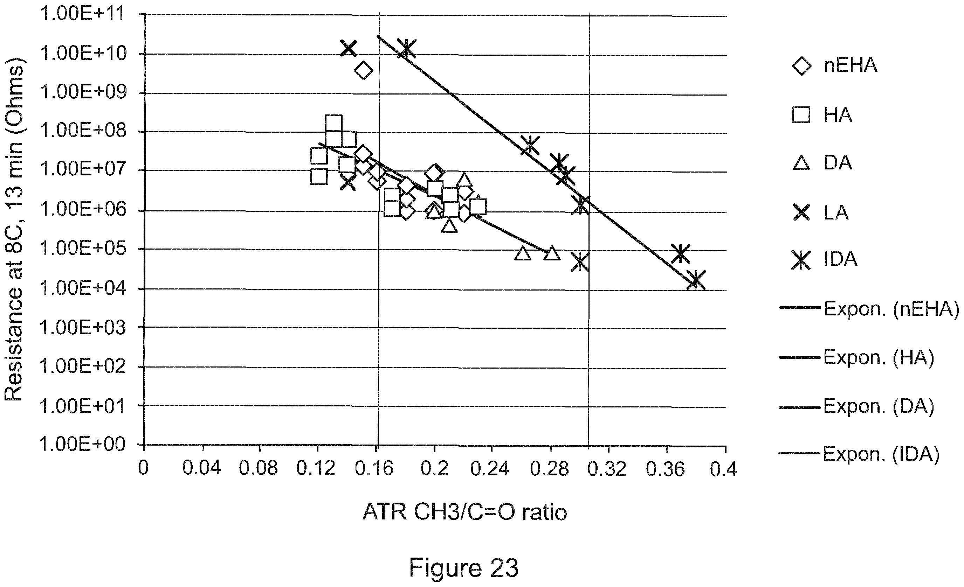

A graph of the resistance in water of several coatings at 8V after 13 min hold versus the FTIR/ATR CH₃/C=O peak area ratio is shown in Figure 23. This graph includes data from coatings formed from the following monomers: ethyl hexyl acrylate, hexyl acrylate, decyl acrylate, lauryl dodecyl acrylate and iso decyl acrylate. :
The structures of decyl acrylate (CAS no. 2156-96-9) and deodecyl(lauryl) acrylate (CAS no. 2156-97-0) are given below:

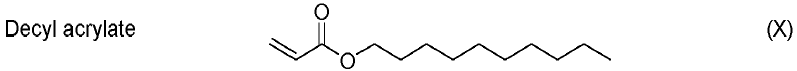

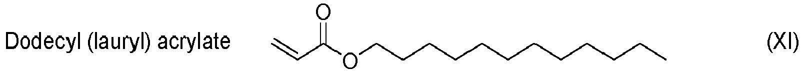

FTIR/ATR analysis of the CH3/C=O peaks for the monomers in Figure 23 show that, with the exception of iso decyl acrylate (IDA), they all produce the desired coatings (i.e. having resistance values higher that 1x10⁷ Ohms) at the same critical ATR ratio CH3/C=O = 0.16±0.01. This critical ATR ratio is independent of chain length. The area limits used for these measurements are shown in Table 11.

The only exception is IDA for which the critical ATR ratio =0.30±0.01, i.e. double that of the coatings formed from the other monomer in Figure 23. This is explained by the fact that IDA has two CH3 terminal groups at the end of the side chain.

The applicants have been able to identify a general chemical structure for both fluorinated and non-fluorinated monomers which gives the desired performance. The monomer is a compound of formula I(a): 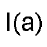 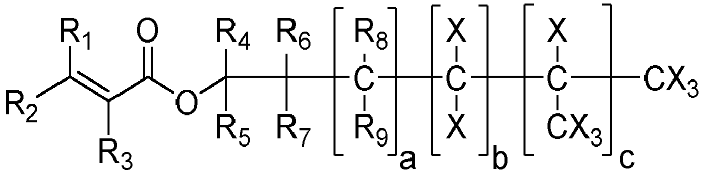
wherein each of R₁ to R₉ is independently selected from hydrogen or a C₁-C₆ branched or straight chain alkyl group; each X is independently selected from hydrogen or halogen; a is from 0-10; b is from 2 to 14; and c is 0 or 1;
and wherein when each X is F the FTIR/ATR intensity ratio of CX₃/C=O of the coating is less than (c+1)0.6e^{-0.1n} ±0.01 where n is a+b+c+1;
and wherein when each X is H the FTIR/ATR intensity ratio of CX₃/C=O is less than (c+1) 0.25±0.02; or
the monomer is a compound of formula I(b): 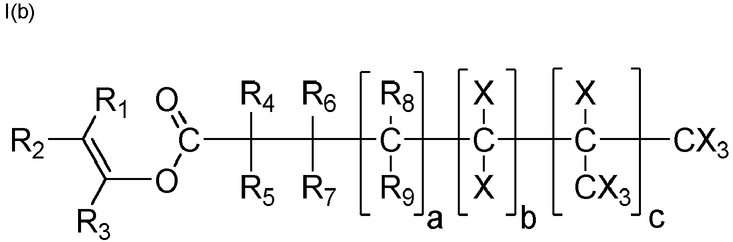 wherein each of R₁ to R₉ is independently selected from hydrogen or a C₁-C₆ branched or straight chain alkyl group; each X is independently selected from hydrogen or halogen; a is from 0-6; b is from 2 to 14; and c is 0 or 1; and wherein when each X is F the FTIR/ATR intensity ratio of CX₃/C=O of the coating is less than (c+1)0.6e^{-0.1n} ±0.01 where n is a+b+c+1; and wherein when each X is H the FTIR/ATR intensity ratio of CX₃/C=O is less than (c+1) 0.25±0.02.

### Example 13

The experiment of example 1 was repeated using vinyl decanoate (CAS no. 4704-31-8). The process parameters and coating properties are shown in table 12.

All of the coatings in the examples have a coating thickness in the range of 250nm to 5000nm. On examination the coatings were found to be conformal and the fact that all of the coatings either exceed the IPX7 test or are close to it are indicative that they form physical barriers. The use of plasma polymerisation to deposit the coating has the advantage that the coating can be made sufficiently thick to provide a physical barrier whilst being significantly thinner than prior art conformal coatings. This thickness range has the advantage that it is sufficiently thick to form a physical barrier yet thin enough to allow electrical connections to be made without first removing it.

The use of plasma polymerisation also has the advantage that good ingress of the monomer during the plasma polymerisation technique ensures that the coating covers all of the desired areas, for example the entire external surface. Where the electronic or electrical device comprises a housing, the entire internal surface of the housing can be coated (by exposing the open housing to the plasma) to protect the electronic components inside the housing once the device is assembled.

**Table 1A: Process parameters and coating properties for coatings formed from PFAC8**

| Monomer: PFAC8 | | | | | | | | |
|---|---|---|---|---|---|---|---|---|
| Parameter | Units | PW processes | | | | | | |
| | | **1** | **2** | **3** | **4** | **5** | **6** | **7** |
| CW time | min | 2 | | 2 | 2 | 2 | 2 | |
| Ton | µs | 36 | | 36 | 36 | 36 | 36 | |
| Toff | ms | 20 | | 6 | 6 | 6 | 6 | |
| monomer pressure | mtorr | 30 | | 30 | 30 | 30 | 30 | |
| PW power | Watts | 50 | | 50 | 50 | 50 | 50 | |
| flow rate (STP) | seem | 2.2 | | 2.20 | 2.2 | 2.63 | 2.63 | |
| Chamber T | °C | 45 | | 45 | 45 | 45 | 45 | |
| PW time | min | 30 | | 10 | 25 | 45 | 15 | |
| power/volume | Watts/litre | 20 | | 20 | 20 | 20 | 20 | |
| power/flow | Watts/(sccm) | 23 | | 23 | 23 | 19 | 19 | |
| monomer volume/min | ml/min | 0.028 | | 0.028 | 0.028 | 0.034 | 0.034 | |

**Table 1B: Process parameters and coating properties for coatings formed from PFAC8**

| Monomer: PFAC8 | | | | | | | | |
|---|---|---|---|---|---|---|---|---|
| Parameter | Units | PW processes | | | | | | |
| | | **1** | **2** | **3** | **4** | **5** | **6** | **7** |
| Thickness (d) Si | nm | 1000 | 1059 | 1185 | 1947 | 3770 | 934 | 1263 |
| Thickness (d) SB | nm | 997 | 1117 | 938 | 1631 | 2760 | 832 | 1150 |
| density (p) | g.cm-3 | | | | 1.6 | 1.83 | | |
| Δρ from monomer | g.cm-3 | | | | 0 | 0.23 | | |
| RMS roughness | nm | | 45±8 | 50±10 | | 26±2 | | 35±3 |
| ΔZ | nm | | 200±20 | 200±50 | | 70±5 | | 80±10 |
| Topography | ΔZ/d by AFM | | 0.19 | 0.17 | | 0.02 | | 0.06 |
| CF3/C=O on SB | | 0.28 | 0.26 | 0.28 | 0.25 | 0.18 | 0.23 | 0.22 |
| R at 8V 13 min | Ω | 8.00E+05 | 6.50E+05 | 1.50E+05 | 2.40E+06 | 1.50E+07 | 1.00E+07 | 3.70E+07 |
| R/d (13min) | Ω/nm | 8.02E+02 | 5.82E+02 | 1.60E+02 | 1.47E+03 | 5.43E+03 | 1.20E+04 | 3.22E+04 |
| Critical force | g | 38 | 60 | 35 | 56 | 44 | 37 | 35 |

**Table: 1C: Process parameters and coating properties for coatings formed from PFAC8**

| Monomer: PFAC8 | | | | | | | | |
|---|---|---|---|---|---|---|---|---|
| Parameter | Units | PW processes | | | | | **CW** | |
| | | **8** | **9** | **10** | **11** | **12** | **13** | **14** |
| CW time | min | 2 | 2 | | 2 | | 10 | 15 |
| Ton | µs | 36 | 36 | | 36 | | n/a | n/a |
| Toff | ms | 6 | 6 | | 6 | | n/a | n/a |
| monomer pressure | mtorr | 30 | 30 | | 30 | | 30 | 30 |
| PW power | Watts | 50 | 50 | | 50 | | 50 | 25 |
| flow rate (STP) | seem | 8.50 | 8.50 | | 19.32 | | 19.32 | 2.60 |
| Chamber T | °C | 45 | 45 | | 45 | | 45 | 45 |
| PW time | min | 5 | 10 | | 10 | | 0 | 0 |
| power/volume | Watts/litre | 20 | 20 | | 20 | | 20 | 10 |
| power/flow | Watts/(sccm) | 6 | 6 | | 3 | | 3 | 9.6 |
| monomer volume/min | ml/min | 0.110 | 0.110 | | 0.250 | | 0.250 | 0.033 |

**Table 1D: Process parameters and coating properties for coatings formed from PFAC8**

| Monomer: PFAC8 | | | | | | | | |
|---|---|---|---|---|---|---|---|---|
| Parameter | Units | PW processes | | | | | **CW** | |
| | | **8** | **9** | **10** | **11** | **12** | **13** | **14** |
| Thickness (d) Si | nm | 798 | 1627 | 2023 | 969 | 1194 | 5258 | 2250 |
| Thickness (d) SB | nm | 1035 | 1466 | 1624 | 1053 | 962 | 5142 | 2620 |
| density (p) | g.cm-3 | | 2.69 | | 2.54 | | 2 | |
| Δρ from monomer | g.cm-3 | | 1.09 | | 0.94 | | 0.4 | |
| RMS roughness | nm | 65±5 | | 50±10 | 80±10 | | | |
| ΔZ | nm | 100±50 | | 175±50 | 150±50 | | | |
| Topography | ΔZ/d by AFM | 0.13 | | 0.09 | 0.13 | | | |
| CF3/C=O on SB | | 0.2 | 0.18 | 0.19 | 0.22 | 0.23 | 0.14 | 0.10 |
| R at 8V 13 min | Ω | 6.00E+07 | 2.30E+08 | 6.20E+08 | 3.80E+07 | 7.40E+06 | 5.40E+07 | 1.44E+10 |
| R/d (13min) | Ω/nm | 5.80E+04 | 1. 57E+05 | 3.82E+05 | 3.61E+04 | 7.69E+03 | 1.05E+04 | 5.50E+06 |
| Critical force | g | 36 | 95 | 98 | 134 | 169 | >1000 | >1000 |

**Table 2: Example of optical properties of coatings**

| | | |
|---|---|---|
| Wavenumber of incident light (nm) | 438.5 | 632.8 |
| Refractive index (n) | 1.3461 | 1.3372 |
| Optical constant (k) | 0.0003 | 0.0001 |

**Table 3: Configuration requirements for thickness measurements (F20 UV)**

| F20 UV | Thickness range | Thickness range when measuring n and k | Precision¹ |
|---|---|---|---|
| | 1 nm - 40 um | 50 nm and up | 0.2 nm |

| | | | |
|---|---|---|---|
| ¹ Standard deviation of 100 thickness readings of 500 nm SiO₂ film on silicon substrate | | | |

**Table 4: Band assignments and integration limits**

| | | |
|---|---|---|
| **Wavenumber (cm-1)** | 1730 | 1335 |
| **Assignment** | C=O | CF3 (s) |
| **Integration limits** | 1840 - 1630 cm-1 | 1357-1309 cm-1 |

**Table 5: Monomer and coating densities (measured by XRR for PFAC8 coatings) and by gravimetric analysis for Parylene C**

| Monomer | Monomer Density (g/cc) | Coating density (g/cc) |
|---|---|---|
| (I) PFAC8 | 1.63 | 1.9 present invention method |
| (II) Parylene C | 1.23 | 1.29 |
| (III) PFAC8 | 1.63 | 1.2 prior art method |

**Table 6: Integration limits for the calculation of ATR ratios of different perfluoro acrylate monomers and the corresponding polymers.**

| | **Assignment** | **C=O (s)** | **CF3 (s)** |
|---|---|---|---|
| **Integration limits** | **PFAC8** | 1840-1640 cm-1 | 1357-1309 cm-1 |
| | **PFAC10** | 1840-1640 cm-1 | 1362-1314 cm-1 |
| | **PFAC6** | 1840-1640 cm-1 | 1376-1329 cm-1 |
| | **PFAC4** | 1840-1640 cm-1 | 1376-1322 cm-1 |

**Table 7: ATR features of different PFACₙ polymers**

| **polymers** | **Spectral areas and peak positions (cm⁻¹)** | | | |
|---|---|---|---|---|
| | **1330-1355** | **1080-1090** | **980-1020** | **840-900** |
| PFAC10 | Single peak 1345 cm⁻¹ | Strong peak 1085 cm⁻¹ | Single peak shoulder 990 cm⁻¹ | strong doublet 888-900 cm⁻¹ |
| PFAC8 | Doublet 1333-1343 cm⁻¹ | Weak peak 1085 cm⁻¹ | Single with shoulder 980 cm⁻¹ | Weak doublet 880-827 cm⁻¹ |
| PFAC6 | doublet 1351-1364 cm⁻¹ | Weak peak 1081 cm⁻¹ | Weak doublet 1010-1020 cm⁻¹ | Strong doublet 845-808 cm⁻¹ |
| PFAC4 | Single strong peak 1353 cm⁻¹ | Very weak peak 1079 cm⁻¹ | shoulder doubled with 1021 cm⁻¹ | Strong Single peak 880 cm⁻¹ |

**Table 8: Integration limits for the calculation of ATR ratios of different perfluoro meth acrylate monomers and the corresponding polymers.**

| | **Assignment** | **C=O (s)** | **CF3 (s)** |
|---|---|---|---|
| **Integration limits** | **PFMAC8** | 1840-1640 cm-1 | 1359-1309 cm-1 |
| | **PFMAC10** | 1840-1640 cm-1 | 1362-1314 cm-1 |
| | **PFMAC6** | 1840-1640 cm-1 | 1376-1329 cm-1 |
| | **PFMAC4** | 1840-1640 cm-1 | 1376-1322 cm-1 |

**Table 9: Properties of CVD prepared Parylene coatings**

| Parylene C | | | | |
|---|---|---|---|---|
| Parameter | units | | | |
| Thickness (d) Si | nm | 1200 | 1500 | 2850 |
| Thickness (d) SB | nm | 1200 | 1500 | 2850 |
| density* (ρ) | g.cm-3 | 1.289 | 1.289 | 1.289 |
| Δρ from monomer | g.cm-3 | 0.06 | 0.06 | 0.06 |
| RMS roughness | nm | 5.2±1 | | |
| ΔZ | nm | 30 | | |
| Topography | ΔZ/d by AFM | 0.025 | | |
| CF3/C=O on SB | | N/A | | |
| R at 8V 13 min | Ω | 1.03E+05 | 1.14E+06 | 2.01E+07 |
| R/d (13min) | Ω/nm | 8.61E+01 | 7.62E+02 | 7.04E+03 |
| Critical force | g | 28±5g | 30±5g | >250 g |

**Table 10: process parameters and coating properties for coatings formed from iso decyl acrylate**

| | Parameter | units | | | | | | | | |
|---|---|---|---|---|---|---|---|---|---|---|
| | Monomer | | IDA | | | | | | | |
| Process | Sample No | | 1 | 2 | 3 | 4 | 5 | 6 | 7 | 8 |
| | CW time | min | 1 | | 1 | | 1 | 1 | | 1 |
| | Ton | µs | 37 | | 37 | | 37 | 37 | | 37 |
| | Toff | ms | 0.1 | | 0.1 | | 0.1 | 0.1 | | 0.1 |
| | monomer pressure | mtorr | 60 | | 60 | | 60 | 60 | | 80 |
| | CW Power | | 50 | | 50 | | 50 | 120 | | 50 |
| | PW power | Watts | 80 | | 80 | | 50 | 120 | | 80 |
| | flow rate | sccm | 4.0 | | 4.0 | | 4.0 | 4.0 | | 4.0 |
| | Chamber T | °C | 45 | | 45 | | 45 | 45 | | 45 |
| | PW time | min | 10 | | 25 | | 30 | 20 | | 20 |
| | power/volume | Watts/litre | 32 | | 32 | | 20 | 48 | | 32 |
| | power/flow | Watts/sccm) | 20 | | 20 | | 12 | 30 | | 20 |
| | monomer volume/min | ml/min | 0.040 | | 0.040 | | 0.040 | 0.040 | | 0.040 |
| | monomer use | g | 0.4 | | 0.9 | | 1.1 | 0.7 | | 0.7 |
| Coating | Thickness | nm | 408 | 462 | 1033 | 1093 | 1861 | 850 | 850 | 643 |
| | CH3/C=O | | 0.3 | 0.3 | 0.29 | 29 | 0.18 | 0.38 | 0.37 | 0.27 |
| performance | Resistance at 8V 13 min | Ω | 1.34E+06 | 4.99E+04 | 8.20E+06 | 1.80E+07 | 1.39E+10 | 1.80E+04 | 8.00E+04 | 4.90E+07 |

**Table 11: Integration limits for the calculation of ATR ratios of different non fluorinated monomers and the corresponding polymers.**

| | **Assignment** | **C=O (s)** | **CF3 (s)** |
|---|---|---|---|
| **Integration limits** | **Iso Decyl Acrylate** | 1845-1630 cm-1 | 1410-1326 cm-1 |
| | **Dodecyl Acrylate** | 1845-1630 cm-1 | 1410-1319 cm-1 |
| | **Hexyl Acrylate** | 1845-1630 cm-1 | 1410-1320 cm-1 |
| | **Ethyl Hexyl Acrylate** | 1845-1630 cm-1 | 1410-1320 cm-1 |

**Table 12: process parameters for forming coatings from Vinyl Decanoate and resultant properties of the coating**

| Parameters | Units | Value |
|---|---|---|
| CWtime | min | 2 |
| Ton | µs | 37 |
| Toff | ms | 0.5 |
| monomer pressure | mtorr | 70 |
| PW/CW power | Watts | 50 |
| monomer flow rate (STP) | sccm | 2 |
| Chamber T | °C | 45 |
| PW time | min | 40 |
| power/volume | Watts/litre | 20 |
| power/flow | Watts/sccm | 25 |
| Resistance | Ohms | 2.3x10⁸ |
| Monomer vol./min | ml/min | 0.018 |
| Thickness | nm | 2150 |
| ATR CH3/C=O | ml/min | 0.20 |

The description and abstract of this specification match those of PCT application number PCT/GB2016/198855 as originally filed, except that the corrected chemical structures filed at the receiving Office on 26 July 2016 have been incorporated herein. The chemical structures as originally filed for PCT/GB2016/198855 are hereby incorporated by reference.

The drawings pages of this specification match those of PCT application number PCT/GB2016/198855 as originally filed, except that the corrected drawings pages filed at the receiving Office on 26 July 2016 have been incorporated herein. The drawings pages as originally filed for PCT/GB2016/198855 are hereby incorporated by reference.

What follows is a series of numbered clauses that describe features of the invention. These numbered clauses match the claims of PCT application number PCT/GB2016/198855 as originally filed, except for the conversion of claims to clauses and except that the corrected chemical structures filed at the receiving Office on 26 July 2016 have been incorporated herein. The chemical structures as originally filed in the claims for PCT/GB2016/198855 are hereby incorporated by reference.
1. An electronic or electrical device or component thereof having a coating formed thereon by exposing said electronic or electrical device or component thereof to a plasma comprising one or more monomer compounds for a sufficient period of time to allow a protective polymeric coating to form on a surface thereof; wherein the protective polymeric coating forms a physical barrier over a surface of the electronic or electrical device or component thereof;
   wherein each monomer is a compound of formula I(a): 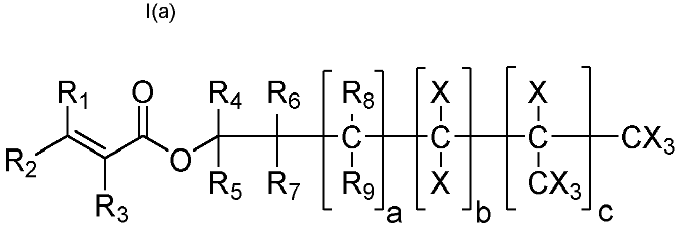 wherein each of R₁ to R₉ is independently selected from hydrogen or halogen or an optionally substituted C₁-C₆ branched or straight chain alkyl group; each X is independently selected from hydrogen or halogen; a is from 0-10; b is from 2 to 14; and c is 0 or 1; and wherein when each X is F or when at least one X is halogen, in particular F, the FTIR/ATR peak intensity ratio of CX₃/C=O of the coating is less than (c+1)0.6e^{-0.1n} ±0.01 where n is a+b+c+1; and wherein when each X is H the FTIR/ATR intensity ratio of CX₃/C=O is less than (c+1) 0.25±0.02; or
   a compound of formula I(b): 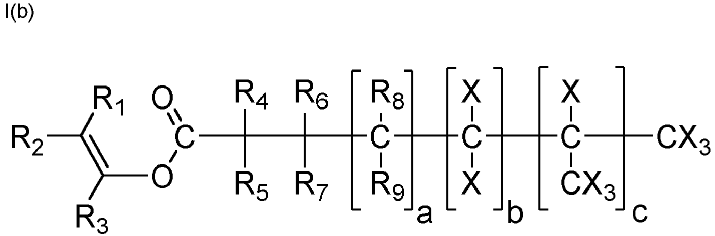 wherein each of R₁ to R₉ is independently selected from hydrogen or halogen or an optionally substituted C₁-C₆ branched or straight chain alkyl group; each X is independently selected from hydrogen or halogen; a is from 0-10; b is from 2 to 14; and c is 0 or 1; and wherein when each X is F or when at least one X is halogen, in particular F, the FTIR/ATR intensity ratio of CX₃/C=O of the coating is less than (c+1)0.6e^{-0.1n} where n is a+b+c+1; and wherein when each X is H the FTIR/ATR intensity ratio of CX₃/C=O is less than (c+1) 0.25±0.02, optionally wherein the barrier is a conformal physical barrier.
2. An electronic or electrical device or component thereof according to clause 1, wherein the halogen is fluorine.
3. An electronic or electrical device or component thereof according to clause 1 or clause 2, wherein each of R₁ to R₉ is independently selected from hydrogen, methyl, ethyl, n-propyl, isopropyl, n-butyl, isobutyl, tert-butyl, sec-butyl, n-pentyl, neopentyl, n-hexyl, isohexyl, and 3-methylpentyl.
4. An electronic or electrical device or component thereof according to clause 3, wherein each of R₁ to R₉ is independently selected from hydrogen or methyl
5. An electronic or electrical device or component thereof according to any preceding clause, wherein a and c are each independently 0 or 1; and b is from 3 to 7.
6. An electronic or electrical device or component thereof according to any preceding clause wherein each X is H.
7. An electronic or electrical device or component thereof according to any of clauses 1 to 5, wherein each X is F.
8. An electronic or electrical device or component thereof according to any preceding clause wherein R₁ and R₂ are both hydrogen.
9. An electronic or electrical device or component thereof according to any preceding clause wherein R₃ is hydrogen or methyl.
10. An electronic or electrical device or component thereof according to any preceding clause, wherein R₈ is hydrogen and R₉ is C₁-C₆ branched or straight chain alkyl group.
11. An electronic or electrical device or component thereof according to clause 10, wherein R₉ is methyl.
12. An electronic or electrical device or component according to any preceding clause, wherein each of R₄ to R₇ is hydrogen.
13. An electronic or electrical device or component according to any preceding clause wherein each of R₁ to R₉ is hydrogen, each X is H, a=0 and c=0.
14. An electronic or electrical device or component thereof according to any of clauses 7 to 12, wherein the compound of formula I(a) has the following formula: 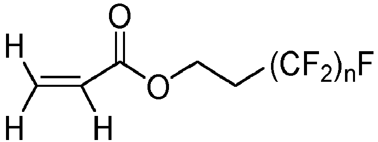 where n is from 2 to 10.
15. An electronic or electrical device or component thereof according to any of clauses 7 to 12, wherein the compound of formula I(a) has the following formula: 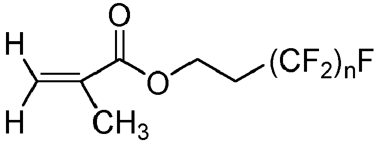 where n is from 2 to 10.
16. An electronic or electrical device or component thereof according to clause 14, wherein the compound of formula I(a) is selected from 1H,1H,2H,2H-perfluorohexyl acrylate (PFAC4), 1H,1H,2H,2H-perfluorooctyl acrylate (PFAC6), 1H,1H,2H,2H-perfluorodecyl acrylate (PFAC8) and 1H,1H,2H,2H-perfluorododecyl acrylate (PFAC10).
17. An electronic or electrical device or component thereof according to clause 15, wherein the compound of formula I(a) is selected from 1H,1H,2H,2H-pefluorohexyl methacrylate (PFMAC4), 1H,1H,2H,2H-perfluorooctyl methacrylate (PFMAC6) and 1H,1H,2H,2H-perfluorodecyl methacrylate (PFMAC8).
18. An electronic or electrical device or component thereof according to any of clauses 8 to 13, wherein the compound of formula I(a) has the following formula: 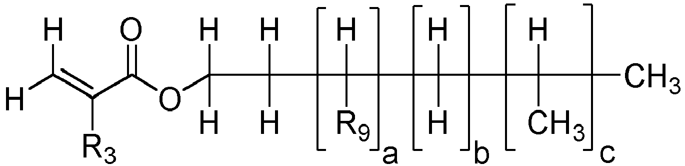 wherein a and c are each independently 0 or 1, b =3-7 and n is 4 to 10, where n=a+b+c+1.
19. An electronic or electrical device or component thereof according to any of clauses 8 to 13, wherein the compound of formula I(a) has the following formula: 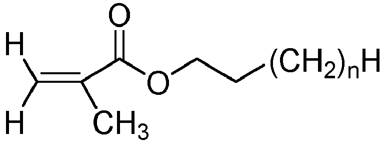 where n is 2 to 12.
20. An electronic or electrical device or component thereof according to clause 18 or clause 19, wherein the compound of formula I(a) is selected from ethyl hexyl acrylate, hexyl acrylate, decyl acrylate, lauryl dodecyl acrylate and iso decyl acrylate.
21. An electronic or electrical device or component thereof according to any of clauses 1 to 13, wherein the compound of formula I(b) has the following formula: 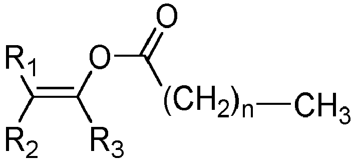 where n is from 3 to 13.
22. An electronic or electrical device or component thereof according to clause 21, wherein the compound of formula I(b) has the following formula: 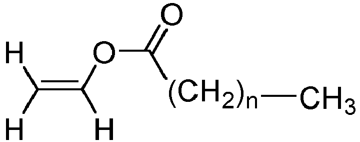 where n is from 3 to 13.
23. An electronic or electrical or component according to any preceding clause, wherein the physical barrier is a conformal physical barrier.
24. An electronic or electrical device or component thereof according to any preceding clause, wherein the electronic or electrical device or component comprises a housing and wherein the coating forms a conformal physical barrier over an internal surface of the housing.
25. An electronic or electrical device or component thereof according to any of the preceding clauses, wherein the coating is substantially pin-hole free.
26. An electronic or electrical device or component thereof according to clause 25, wherein ΔZ/d is less than 0.15, where ΔZ is the average height variation on an AFM line scan in nm and d is coating thickness in nm.
27. An electronic or electrical device or component thereof according to any of the preceding clauses, wherein the coating is electrically insulating.
28. An electronic or electrical device or component thereof according to any of the preceding clauses, wherein the electronic or electrical device or component thereof can withstand immersion in up to 1m of water for over 30 minutes without failure or corrosion whilst power applied to electronic or electrical device or component.
29. An electronic or electrical device or component according to any of the preceding clauses, wherein the coating has a resistance of 8 MOhms or higher when submerged in water and a voltage of 8V is applied for 13 minutes.
30. An electronic or electrical device or component according to one of the preceding clauses, wherein the coating has a thickness of 50nm - 10,000nm.
31. An electronic or electrical device or component according to any one of the preceding clauses, wherein the coating has a thickness of 250nm - 2000nm.
32. An electronic or electrical device or component according to any of the preceding clauses, wherein the coating is electrically insulating and wherein the coating is sufficiently compliant that electrical connectors can be joined to the electronic or electrical device or component thereof and an electrical connection made between the electrical connectors and electronic or electrical device or component thereof without the requirement to first remove the coating.
33. An electronic or electrical device or component according to any of the preceding clauses, wherein the coating is electrically insulating and has a thickness of 1-2.5 microns and wherein a force of 20-100g applied to the coating allows an electrical connection to be made with the electronic or electrical device or component thereof in the local area where the force has been applied.
34. An electronic or electrical device or component according to any of the preceding clauses, wherein the coating is electrically insulating and has a thickness of less than 1 micron and wherein a force of less than 5-20g applied to the coating allows an electrical connection to be made in the local area of the coating where the force has been applied
35. An electronic or electrical device or component thereof according to any of the preceding clauses wherein the coating forms a water repellent surface defined by a static water contact angle (WCA) of at least 90°.
36. An electronic or electrical device or component thereof according to any of the preceding clauses, wherein X is F and wherein the coating forms a water repellent surface defined by a static water contact angle (WCA) of at least 100°.
37. An electronic or electrical device or component thereof according to any of the preceding clauses, wherein the electronic or electrical device or component thereof is selected from mobile phones, smartphones, pagers, radios, sound and audio systems such as loudspeakers, microphones, ringers and/or buzzers, hearing aids, personal audio equipment such as personal CD, tape cassette or MP3 players, televisions, DVD players including portable DVD players, video recorders, digi and other set-top boxes, computers and related components such as laptop, notebook, tablet, phablet or palmtop computers, personal digital assistants (PDAs), keyboards, or instrumentation, games consoles, data storage devices, outdoor lighting systems, radio antennae and other forms of communication equipment, and printed circuit boards.
38. A method for treating an electronic or electrical device or component thereof as defined in any preceding clause, comprising:
   exposing said electronic or electrical device or component thereof to a plasma comprising one or more monomer compounds for a sufficient period of time to allow a protective polymeric coating to form on the electronic or electrical device or component thereof, the protective polymeric coating forming a physical barrier over a surface of said electronic or electrical device or component thereof;
   wherein each monomer is a compound of formula (Ia): 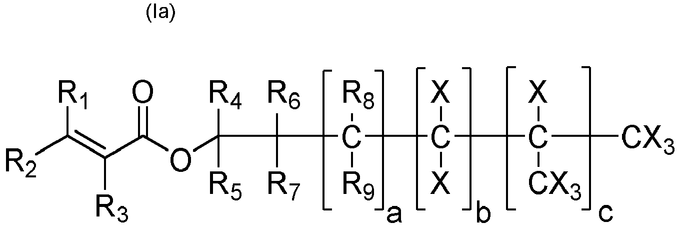 wherein each of R₁ to R₉ is independently selected from hydrogen or halogen or an optionally substituted C₁-C₆ branched or straight chain alkyl group; each X is independently selected from hydrogen or halogen; a is from 0-10; b is from 2 to 14; and c is 0 or 1; or
   a compound of formula (Ib): 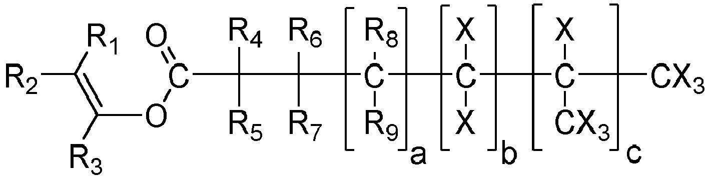 wherein each of R₁ to R₉ is independently selected from hydrogen or halogen or an optionally substituted C₁-C₆ branched or straight chain alkyl group; each X is independently selected from hydrogen or halogen; a is from 0-10; b is from 2 to 14; and c is 0 or 1.
39. A method according to clause 38 wherein the barrier is a conformal physical barrier.
40. A method according to clause 38 or clause 39, wherein the step of exposing said electronic or electrical device or component thereof to a plasma comprises a first continuous wave (CW) deposition step and second pulsed (PW) deposition step.
41. A method according to clause 40 wherein the pulses of the pulsed plasma are applied in a sequence which yields a ratio of time on : time off in the range of from 0.001 to 1.
42. A method according to clause 40 to 41, wherein the pulsing conditions are time on = 10-500 µs and time off = 0.1 to 30 ms.
43. A method according to any of clauses 40 to 42, wherein the monomer is introduced during the pulsing at a flow rate of between 1.5 to 2500 sccm.
44. A method according to any of clauses 40 to 44, wherein the power to monomer flow ratio during the pulsed plasma is between 2-60 W/sccm.
45. A method according to any of clauses 38 to 44, wherein the compound of formula I(a) is selected from 1H,1H,2H,2H-perfluorohexyl acrylate (PFAC4), 1H,1H,2H,2H-perfluorooctyl acrylate (PFAC6), 1H,1H,2H,2H-perfluorodecyl acrylate (PFAC8) and 1H,1H,2H,2H-perfluorododecyl acrylate (PFAC10).
46. A method according to any of clauses 38 to 44, wherein the compound of formula I(a) is selected from 1H,1H,2H,2H-pefluorohexyl methacrylate (PFMAC4), 1H,1H,2H,2H-perfluorooctyl methacrylate (PFMAC6) and 1H,1H,2H,2H-perfluorodecyl methacrylate (PFMAC8).
47. A method according to any of clauses 38 to 44 wherein the compound of formula I(a) is selected from ethyl hexyl acrylate, hexyl acrylate, decyl acrylate, lauryl dodecyl acrylate and iso decyl acrylate.
48. A method according to any of clauses 38 to 47, further comprising a preliminary activation step of applying a CW plasma in the presence of an inert gas.
49. An electronic or electrical device comprising a housing and an internal electronic or electrical component, wherein the internal component comprises a coating, wherein the coating is formed by any of the methods of clauses 38 to 48 and/or the internal component is a component according to any one of clauses 1 to 37.
50. A method according to any of clauses 38 to 49, wherein the electronic or electrical device or component thereof is selected from mobile phones, smartphones, pagers, radios, sound and audio systems such as loudspeakers, microphones, ringers and/or buzzers, hearing aids, personal audio equipment such as personal CD, tape cassette or MP3 players, televisions, DVD players including portable DVD players, video recorders, digi and other set-top boxes, computers and related components such as laptop, notebook, tablet, phablet or palmtop computers, personal digital assistants (PDAs), keyboards, or instrumentation, games consoles, data storage devices, outdoor lighting systems, radio antennae and other forms of communication equipment.

## Claims

1. An electronic or electrical device or component thereof having a coating formed thereon by exposing said electronic or electrical device or component thereof to a plasma comprising one or more monomer compounds for a sufficient period of time to allow a protective polymeric coating to form on a surface thereof; wherein the protective polymeric coating forms a physical barrier over a surface of the electronic or electrical device or component thereof;
wherein each monomer is a compound of formula I(a): 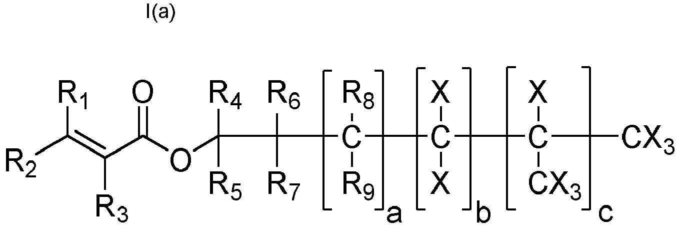 wherein each of R₁ to R₉ is independently selected from hydrogen or halogen or an optionally substituted C₁-C₆ branched or straight chain alkyl group; each X is independently selected from hydrogen or halogen; a is from 0-10; b is from 2 to 14; and c is 0 or 1; and wherein when each X is F or when at least one X is halogen, in particular F, the FTIR/ATR peak intensity ratio of CX₃/C=O of the coating is less than (c+1)0.6e^{-0.1n} ±0.01 where n is a+b+c+1; and wherein when each X is H the FTIR/ATR intensity ratio of CX₃/C=O is less than (c+1) 0.25±0.02; or
a compound of formula I(b): 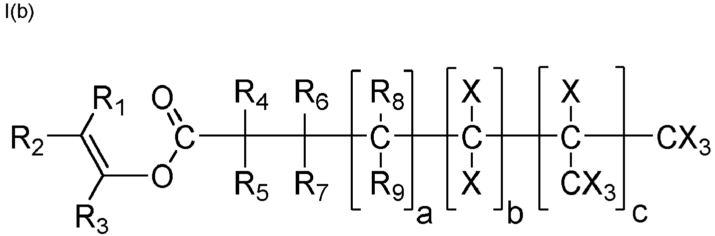 wherein each of R₁ to R₉ is independently selected from hydrogen or halogen or an optionally substituted C₁-C₆ branched or straight chain alkyl group; each X is independently selected from hydrogen or halogen; a is from 0-10; b is from 2 to 14; and c is 0 or 1; and wherein when each X is F or when at least one X is halogen, in particular F, the FTIR/ATR intensity ratio of CX₃/C=O of the coating is less than (c+1)0.6e^{-0.1n} where n is a+b+c+1; and wherein when each X is H the FTIR/ATR intensity ratio of CX₃/C=O is less than (c+1) 0.25±0.02, optionally wherein the barrier is a conformal physical barrier.

2. An electronic or electrical device or component thereof according to claim 1, wherein the compound of formula I(a) has the following formula: 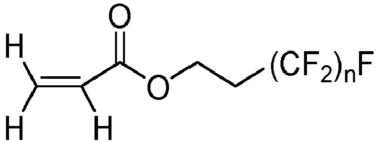 where n is from 2 to 10,
optionally wherein the compound of formula I(a) is selected from 1H,1H,2H,2H-perfluorohexyl acrylate (PFAC4), 1H,1H,2H,2H-perfluorooctyl acrylate (PFAC6), 1H,1H,2H,2H-perfluorodecyl acrylate (PFAC8) and 1H,1H,2H,2H-perfluorododecyl acrylate (PFAC10),
or wherein the compound of formula I(a) has the following formula: 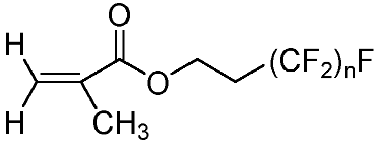 where n is from 2 to 10,
optionally wherein the compound of formula I(a) is selected from 1H,1H,2H,2H-pefluorohexyl methacrylate (PFMAC4), 1H,1H,2H,2H-perfluorooctyl methacrylate (PFMAC6) and 1H,1H,2H,2H-perfluorodecyl methacrylate (PFMAC8),
or wherein the compound of formula I(a) has the following formula: 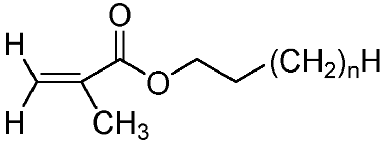 where n is 2 to 12,
optionally wherein the compound of formula I(a) is selected from ethyl hexyl acrylate, hexyl acrylate, decyl acrylate, lauryl dodecyl acrylate and iso decyl acrylate.

3. An electronic or electrical device or component thereof according to claim 1, wherein the compound of formula I(b) has the following formula: 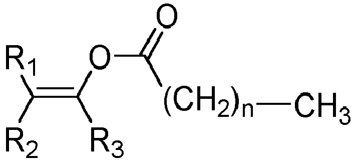 where n is from 3 to 13,
optionally wherein the compound of formula I(b) has the following formula: 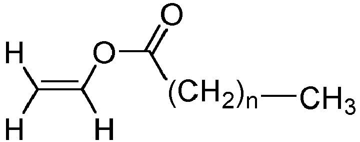 where n is from 3 to 13.

4. An electronic or electrical device or component thereof according to any preceding claim, wherein the physical barrier is a conformal physical barrier.

5. An electronic or electrical device or component thereof according to any preceding claim, wherein the electronic or electrical device or component comprises a housing and wherein the coating forms a conformal physical barrier over an internal surface of the housing.

6. An electronic or electrical device or component thereof according to any preceding claim, wherein the electronic or electrical device comprises a housing and further comprises one or more internal electronic or electrical components with the coating formed thereon.

7. An electronic or electrical device or component thereof according to claim 6, wherein the housing does not comprise a coating, optionally wherein the electronic or electrical device is a mobile phone.

8. An electronic or electrical device or component thereof according to any of the preceding claims, wherein the coating is substantially pin-hole free, preferably wherein ΔZ/d is less than 0.15, where ΔZ is the average height variation on an AFM line scan in nm and d is coating thickness in nm.

9. An electronic or electrical device or component according to any of the preceding claims, wherein the coating has a resistance of 8 MOhms or higher when submerged in water and a voltage of 8V is applied for 13 minutes.

10. An electronic or electrical device or component according to any of the preceding claims, wherein the coating has a thickness of 50nm - 10,000nm, preferably wherein the coating has a thickness of 250nm - 2000nm.

11. An electronic or electrical device or component according to any of the preceding claims, wherein the coating is electrically insulating and wherein the coating is sufficiently compliant that electrical connectors can be joined to the electronic or electrical device or component thereof and an electrical connection made between the electrical connectors and electronic or electrical device or component thereof without the requirement to first remove the coating, preferably wherein the coating is electrically insulating and has a thickness of 1-2.5 microns and wherein a force of 20-100g applied to the coating allows an electrical connection to be made with the electronic or electrical device or component thereof in the local area where the force has been applied, or wherein the coating is electrically insulating and has a thickness of less than 1 micron and wherein a force of less than 5-20g applied to the coating allows an electrical connection to be made in the local area of the coating where the force has been applied

12. An electronic or electrical device or component thereof according to any of the preceding claims wherein the coating forms a water repellent surface defined by a static water contact angle (WCA) of at least 90°, preferably wherein X is F and wherein the coating forms a water repellent surface defined by a static water contact angle (WCA) of at least 100°.

13. A method for treating an electronic or electrical device or component thereof, comprising:
exposing said electronic or electrical device or component thereof to a plasma comprising one or more monomer compounds for a sufficient period of time to allow a protective polymeric coating to form on the electronic or electrical device or component thereof, the protective polymeric coating forming a physical barrier over a surface of said electronic or electrical device or component thereof;
wherein each monomer is a compound of formula (Ia): 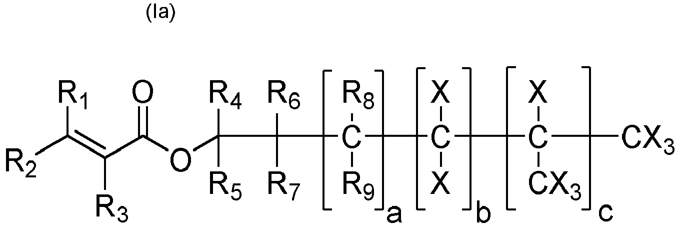 wherein each of R₁ to R₉ is independently selected from hydrogen or halogen or an optionally substituted C₁-C₆ branched or straight chain alkyl group; each X is independently selected from hydrogen or halogen; a is from 0-10; b is from 2 to 14; and c is 0 or 1; or
a compound of formula (Ib): 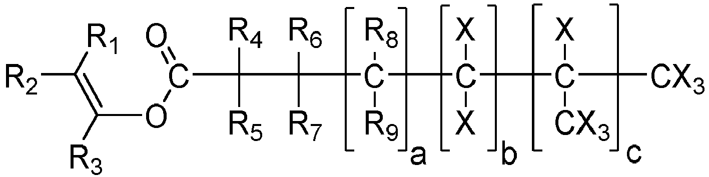 wherein each of R₁ to R₉ is independently selected from hydrogen or halogen or an optionally substituted C₁-C₆ branched or straight chain alkyl group; each X is independently selected from hydrogen or halogen; a is from 0-10; b is from 2 to 14; and c is 0 or 1.

14. A method according to claim 13, wherein the step of exposing said electronic or electrical device or component thereof to a plasma may comprise a two step process, in which the first and second steps comprise different plasma conditions.

15. A coated substrate obtainable by the method of claim 13 or claim 14.
